# EUROPEAN PATENT SPECIFICATION

(11) **EP 2 381 501 B1**
(45) Date of publication and mention of the grant of the patent: **23.07.2014**
(21) Application number: 09838880.4
(22) Date of filing: 25.12.2009
(51) Int. Cl.: H01L 51/54, C09K 11/06, C07F 15/00

(54) **ORGANIC ELECTROLUMINESCENT ELEMENT**
ORGANISCHES ELEKTROLUMINESZENZELEMENT
ÉLÉMENT ÉLECTROLUMINESCENT ORGANIQUE

(30) Priority: 22.01.2009 JP 2009012389
(43) Date of publication of application: 26.10.2011
(73) Proprietor: UDC Ireland Limited, Dublin 4 (IE)
(72) Inventor: MASUI, Kensuke, Ashigarakami-gun Kanagawa 258-8577 (JP); HAYASHI, Masayuki, Ashigarakami-gun Kanagawa 258-8577 (JP)
(74) Representative: HOFFMANN EITLE
(86) International application number: PCT/JP2009/071557
(87) International publication number: WO 2010/084690

(56) References cited:
- EP-A1- 1 549 112
- WO-A1-2004/028217
- WO-A1-2004/034751
- WO-A1-2005/076669
- WO-A1-2006/033440
- JP-A- 2004 217 547
- JP-A- 2009 283 891

## Description

### BACKGROUND OF THE INVENTION

### Field of the Invention

The present invention relates to an organic electroluminescence element (which may be, hereinafter, referred to as "organic electroluminescent element", or "organic EL element)".

### Background Art

Organic electroluminescence elements have advantages of self-light emission and high-speed responsiveness and are expected to be used in flat panel display devices. Particularly, since a two-layered (multi-layered) organic EL element in which a hole-transporting organic thin film (hole transporting layer) and an electron transporting organic thin film (electron transporting layer) are laminated was reported, large-area light emitting element which emit light at a low voltage of 10 V or lower have attracted great interest. A multi-layered organic EL element basically includes a positive electrode, a hole transporting layer, a light emitting layer, an electron transporting layer and a negative electrode, among which the hole transporting layer or the electron transporting layer may function as the light emitting layer as in the case with the two-layered organic EL element.

In order to simultaneously achieve low-voltage supply and high light-emission efficiency in such organic EL elements, various studies have been made. For example, PTL 1 describes that by using, as a highly electron-transporting material, a specific nitrogen-containing heterocyclic derivative in an electron injection layer and an electron transporting layer, low-voltage supply and high light-emission efficiency can be achieved. Surely, when the highly electron-transporting material described in PTL 1 is used, the driving voltage can be reduced, but there is a problem that when a phosphorescence emission material is used in a light emitting layer, it causes a reduction in light emission efficiency. This can be considered as follows. When a commonly used hole transporting material is used as a host material, most of phosphorescence emission materials are hole transportable, and when electrons are excessively injected into the light emitting layer, the flow of the electrons remains sluggish in the light emitting layer, the carrier balance between electrons and holes is off-balance, and as a result, the reduction in light emission efficiency occurs.

Although PTL 1 discloses examples of using fluorescence light emission elements, there is no description about examples using phosphorescence materials, there is no suggestion about problems with a reduction in light emission efficiency in the case where a phosphorescence emission material is used, and there is no disclosure nor suggestion about techniques required when a phosphorescence material is used.

### Citation List

### Patent Literature

PTL 1 Japanese Patent Application Laid-Open (JP-A) No. 2004-217547

EP 1 549 112 describes an organic electroluminescence device comprising a cathode, an anode and an organic thin film layer which is sandwiched between the cathode and the anode and comprises at least one layer containing a light emitting layer comprising a phosphorescent light emitting compound.

WO 2006/033440 describes an organic electroluminescent device having a pair of electrodes and at least one organic layer including a light-emitting layer interposed between the pair of electrodes, in which the organic layer contains at least one platinum chelate complex of a specific formula, having a tetradentate ligand.

### Summary of Invention

The present invention aims to provide an organic electroluminescence element capable of reducing voltage of driving voltage and maintaining high light emission efficiency.

### Solution to Problem

The present inventors carried out extensive studies and examinations to solve the above-mentioned problems and have found that by using a phosphorescence light emitting material having high electron-transportability in combination with a high electron transporting material, the flow of electrons in a light emitting layer is increased, the carrier balance of holes with electrons is improved and thereby the voltage can be reduced and high efficiency can be simultaneously achieved, and particularly when a phosphorescence light emitting material of a platinum complex compound containing a tetradentate ligand is used, high efficiency and a low driving voltage can be achieved.

The present invention has been made based on the present inveontors' findings, and means for solving the above-mentioned problems are as follows:
< 1 > An organic electroluminescence element including:
   at least one organic layer including a light emitting layer, between an anode and a cathode,
   wherein at least one layer of the at least one organic layer contains at least one selected from nitrogen-containing heterocyclic derivatives represented by General Formula (1) below, and at least one layer of the at least one organic layer contains an electron-transporting phosphorous light emitting material represented by General Formula (15a-3) below, 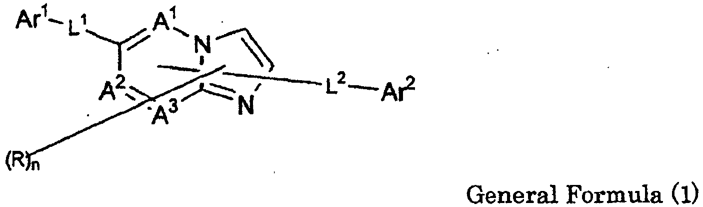 where A¹ to A³ each independently represent a nitrogen atom or a carbon atom, Ar¹ represents a substituted or unsubstituted aryl group having nucleus carbon atoms of 6 to 60 or a substituted or unsubstituted heteroaryl group having nucleus carbon atoms of 3 to 60, Ar² represents a hydrogen atom, a substituted or unsubstituted aryl group having nucleus carbon atoms of 6 to 60, a substituted or unsubstituted heteroaryl group having nucleus carbon atoms of 3 to 60, a substituted or unsubstituted alkyl group having 1 to 20 carbon atoms or a substituted or unsubstituted alkoxy group having 1 to 20 carbon atoms, wherein one of Ar¹ and Ar² is a substituted or unsubstituted condensed ring group having 10 to 60 nucleus carbon atoms or a substituted or unsubstituted monohetero condensed ring group having 3 to 60 nucleus carbon atoms; L¹ and L² each independently represent a single bond, a substituted or unsubstituted arylene group having 6 to 60 nucleus carbon atoms, a substituted or unsubstituted heteroarylene group having 3 to 60 nucleus carbon atoms or a substituted or unsubstituted fluorenylene group; R represents a hydrogen atoms, a substituted or unsubstituted aryl group having 6 to 60 nucleus carbon atoms, a substituted or unsubstituted heteroaryl group having nucleus carbon atoms of 3 to 60, a substituted or unsubstituted alkyl group having 1 to 20 carbon atoms or a substituted or unsubstituted alkoxy group having 1 to 20 carbon atoms; and n is an integer of 0 to 5, when n is 2 or greater, a plurality of Rs may be different from or identical to each other, and adjacent R groups among the plurality of Rs may be bonded to form a carbocyclic aliphatic ring or a carbocyclic aromatic ring, 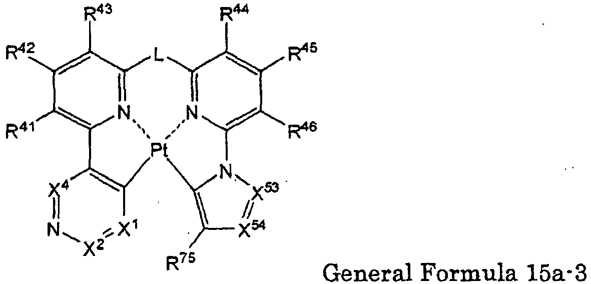 where X¹, X² and X⁴ each independently represent a carbon atom or a nitrogen atom; R⁴¹, R⁴², R⁴³, R⁴⁴, R⁴⁵ and R⁴⁶ each independently represent a hydrogen atom or a substituent; X⁵³ and X⁵⁴ each independently represent a carbon atom or a nitrogen atom, the number of nitrogen atoms contained in a 5-membered ring skeleton containing X⁵³ and X⁵⁴ is 1 or 2; R⁷⁵ represents a hydrogen atom or a substituent; and L represents a single bond or a divalent linking group.
< 2 > The organic electroluminescence element according to < 1 >, wherein at least one selected from the nitrogen-containing heterocyclic derivatives represented by General Formula (1) is a nitrogen-containing heterocyclic derivative represented by General Formula (3) below, 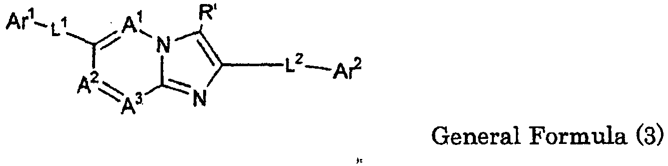 where A¹ to A³ each independently represent a nitrogen atom or a carbon atom, Ar¹ represents a substituted or unsubstituted aryl group having nucleus carbon atoms of 6 to 60 or a substituted or unsubstituted heteroaryl group having nucleus carbon atoms of 3 to 60, Ar² represents a hydrogen atom, a substituted or unsubstituted aryl group having nucleus carbon atoms of 6 to 60, a substituted or unsubstituted heteroaryl group having nucleus carbon atoms of 3 to 60, a substituted or unsubstituted alkyl group having 1 to 20 carbon atoms or a substituted or unsubstituted alkoxy group having 1 to 20 carbon atoms, wherein one of A^{r1} and Ar² is a substituted or unsubstituted condensed ring group having nucleus carbon atoms of 10 to 60 or a substituted or unsubstituted monohetero condensed ring group having nucleus carbon atoms of 3 to 60; L¹ and L² each independently represent a single bond, a substituted or unsubstituted arylene group having 6 to 60 nucleus carbon atoms, a substituted or unsubstituted heteroarylene group having 3 to 60 nucleus carbon atoms or a substituted or unsubstituted fluorenylene group; and R' represents a hydrogen atom, a substituted or unsubstituted aryl group having 6 to 60 nucleus carbon atoms, a substituted or unsubstituted heteroaryl group having 3 to 60 nucleus carbon atoms, a substituted or unsubstituted alkyl group having 1 to 20 carbon atoms or a substituted or unsubstituted alkoxy group having 1 to 20 carbon atoms.
< 3 > The organic electroluminescence element according to < 2 >, wherein the nitrogen-containing heterocyclic derivative represented by General Formula (3) is a nitrogen-containing heterocyclic derivative represented by General Formula (4). 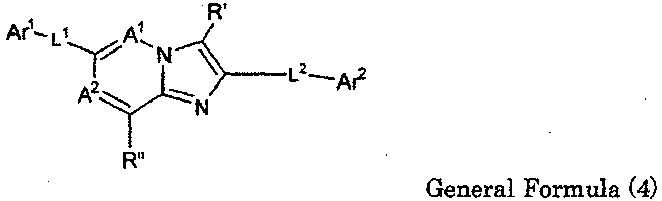 where A¹ and A² each independently represent a nitrogen atom or a carbon atom, Ar¹ represents a substituted or unsubstituted aryl group having nucleus carbon atoms of 6 to 60 or a substituted or unsubstituted heteroaryl group having nucleus carbon atoms of 3 to 60, Ar² represents a hydrogen atom, a substituted or unsubstituted aryl group having nucleus carbon atoms of 6 to 60, a substituted or unsubstituted heteroaryl group having nucleus carbon atoms of 3 to 60, a substituted or unsubstituted alkyl group having 1 to 20 carbon atoms or a substituted or unsubstituted alkoxy group having 1 to 20 carbon atoms, wherein one of Ar¹ and Ar² is a substituted or unsubstituted condensed ring group having 10 to 60 nucleus carbon atoms or a substituted or unsubstituted monohetero condensed ring group having 3 to 60 nucleus carbon atoms; L¹ and L² each independently represent a single bond, a substituted or unsubstituted arylene group having 6 to 60 nucleus carbon atoms, a substituted or unsubstituted heteroarylene group having 3 to 60 nucleus carbon atoms or a substituted or unsubstituted fluorenylene group; and R' and R" each independently represent a hydrogen atom, a substituted or unsubstituted aryl group having 6 to 60 nucleus carbon atoms, a substituted or unsubstituted heteroaryl group having 3 to 60 nucleus carbon atoms, a substituted or unsubstituted alkyl group having 1 to 20 carbon atoms or a substituted or unsubstituted alkoxy group having 1 to 20 carbon atoms, R' and R" may be different from or identical to each other.
< 4 >The organic electroluminescence element according to any one of < 1 > to < 3 >, wherein in the nitrogen-containing heterocyclic derivative represented by any one of General Formulae (1), (3) and (4), at least one of L¹ and L² is selected from groups each independently represented by Structural Formulae below: 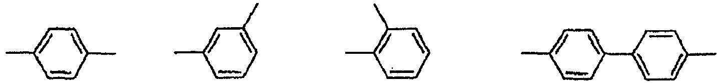 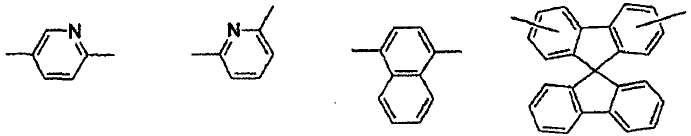
< 5 > The organic electroluminescence element according to any one of < 1 > to < 4 >, wherein in the nitrogen-containing heterocyclic derivative represented by any one of General Formulae (1), (3) and (4), Ar¹ is a group represented by any one of General Formulae (5) to (14) below: 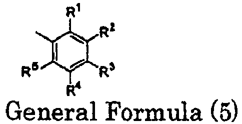 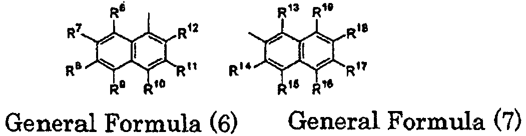 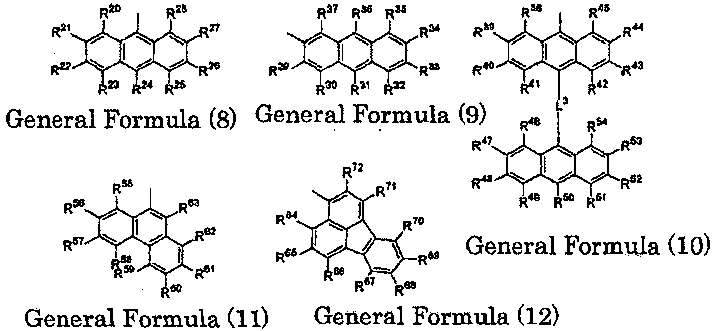 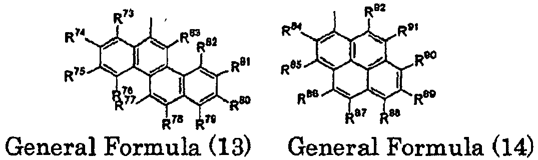 where R¹ to R⁹² each independently represent a hydrogen atom, a halogen atom, a substituted or unsubstituted alkyl group having 1 to 20 carbon atoms, a substituted or unsubstituted alkoxy group having 1 to 20 carbon atoms, a substituted or unsubstituted aryloxy group having 6 to 40 nucleus carbon atoms, a substituted or unsubstituted diarylamino group having 12 to 80 nucleus carbon atoms, a substituted or unsubstituted aryl group having 6 to 40 nucleus carbon atoms, a substituted or unsubstituted heteroaryl group having 3 to 40 nucleus carbon atoms, or a substituted or unsubstituted diarylaminoaryl group having 18 to 120 nucleus carbon atoms; and L³ represents a single bond or a substituent represented by any one of Structural Formulae below: 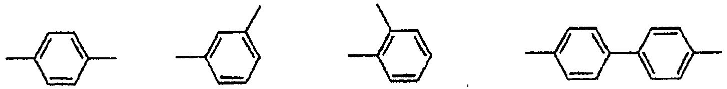 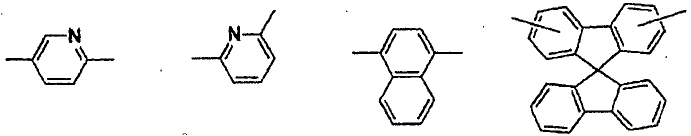
< 6 > The organic electroluminescence element according to any one of < 1 > to < 5 >, wherein the light emitting layer contains a metal complex compound containing a polydentate ligand having a partial structure represented by General Formula (2) and at least one of platinum complex compounds containing a tetradentate ligand represented by General Formula, (15a-3): 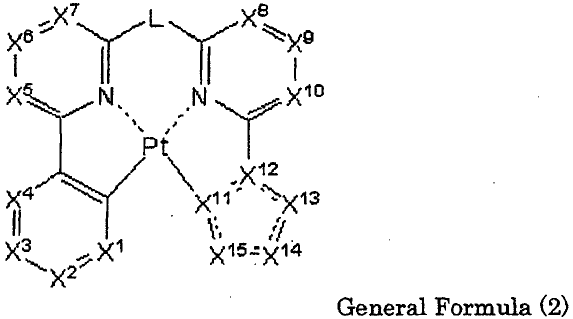 where X¹, X², X³ and X⁴ each independently represent a carbon atom or a nitrogen atom, and one or more selected from X¹, X², X³and X⁴ represent(s) a nitrogen atom; X⁵, X⁶, X⁷, X⁸, X⁹ and X¹⁰ each independently represent a carbon atom or a nitrogen atom; X¹¹ and X¹² each independently represent a carbon atom or a nitrogen atom; X¹³, X¹⁴ and X¹⁵ each independently represent a carbon atom, a nitrogen atom, an oxygen atom or a sulfur atom, the number of nitrogen atoms contained in a five-membered ring skeleton represented by any one of X¹¹, X¹², X¹³, X¹⁴ and X¹⁵ is 2 or smaller; and L represents a single bond or a divalent linking group. 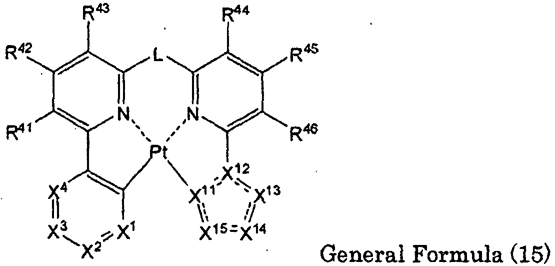
   In General Formula (15), X¹, X², X³ and X⁴ each independently represent a carbon atom or a nitrogen atom and one or more selected from X¹, X², X³ and X⁴ represents or represent a nitrogen atom; R⁴¹, R⁴², R⁴³, R⁴⁴, R⁴⁵ and R⁴⁶ each independently represent a hydrogen atom or a substituent; X¹¹ and X¹² each independently represent a carbon atom or a nitrogen atom;, X¹³, X¹⁴ and X¹⁵ each independently represent a carbon atom, a nitrogen atom or a sulfur atom, the number of nitrogen atoms contained in a five-membered ring skeleton represented by any one of X¹¹, X¹², X¹³, X¹⁴ and X¹⁵ is 2 or smaller; and L represents a single bond or a divalent linking group. 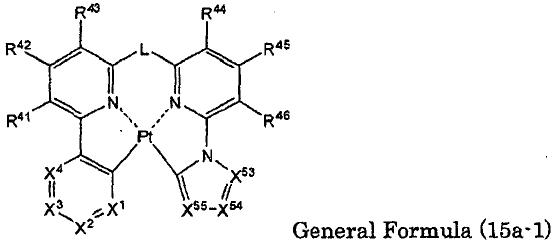 where X¹, X², X³ and X⁴ each independently represent a carbon atom or a nitrogen atom, one or more selected from X¹, X², X³ and X⁴ represents a nitrogen atom; R⁴¹, R⁴², R⁴³, R⁴⁴, R⁴⁵ and R⁴⁶ each independently represent a hydrogen atom or a substituent; X⁵³, X⁵⁴ and X⁵⁵ each independently represent a carbon atom or a nitrogen atom, and the number of nitrogen atoms contained in a five-membered ring skeleton containing X⁵³, X⁵⁴ and X⁵⁵ is 1 or 2; and L represents a single bond or a divalent linking group. 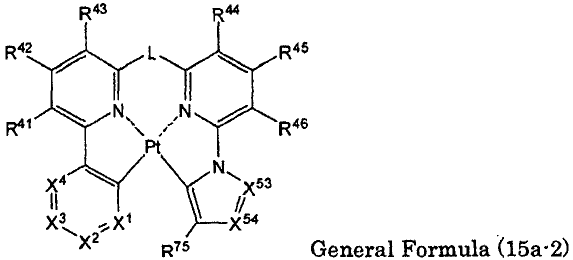 where X¹, X², X³ and X⁴ each independently represent a carbon atom or a nitrogen atom, one or more selected from X¹, X², X³ and X⁴ represents a nitrogen atom; R⁴¹, R⁴², R⁴³, R⁴⁴, R⁴⁵ and R⁴⁶ each independently represent a hydrogen atom or a substituent; X⁵³ and X⁵⁴ each independently represent a carbon atom or a nitrogen atom, and the number of nitrogen atoms contained in a five-membered ring skeleton containing X⁵³ and X⁵⁴ is 1 or 2; R⁷⁵ represents a hydrogen atom or a substituent; and L represents a single bond or a divalent linking group. 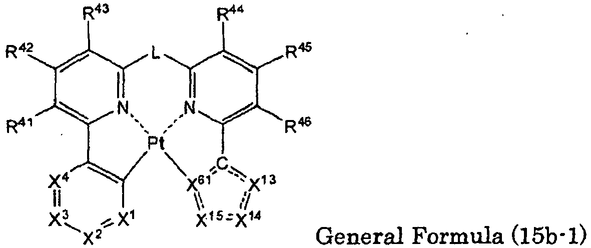 where X¹, X², X³ and X⁴ each independently represent a carbon atom or a nitrogen atom, one or more selected from X¹, X², X³ and X⁴ represents a nitrogen atom; R⁴¹, R⁴², R⁴³, R⁴⁴, R⁴⁵ and R⁴⁶ each independently represents a hydrogen atom or a substituent; X⁶¹ represents a carbon atom or a nitrogen atom; X¹³, X¹⁴ and X¹⁵ each independently represent a carbon atom, a nitrogen atom, an oxygen atom or a sulfur atom; the number of nitrogen atoms contained in a five-membered ring skeleton containing X⁶¹, a carbon atom, X¹³, X¹⁴ and X¹⁵ is 2 or less; and L represents a single bond or a divalent linking group. 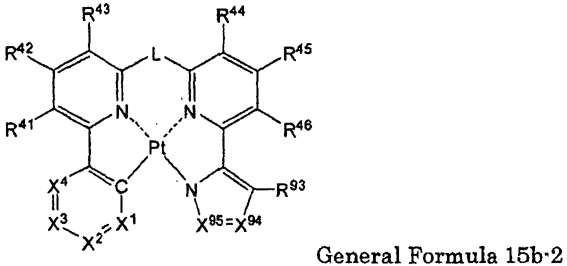 where X¹, X², X³ and X⁴ each independently represent a carbon atom or a nitrogen atom, one or more selected from X¹, X², X³ and X⁴ represents a nitrogen atom; R⁴¹, R⁴², R⁴³, R⁴⁴, R⁴⁵ and R⁴⁶ each independently represent a hydrogen atom or a substituent; X⁹⁴ and X⁹⁵ each independently represent a carbon atom or a nitrogen atom, and at least one of X⁹⁴ and X⁹⁵ represents a carbon atom; R⁹³ represents a hydrogen atom or a substituent; and L represents a single bond or a divalent linking group. 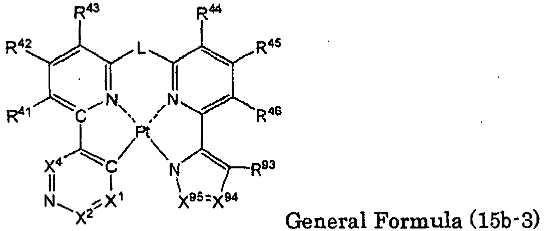 where X¹, X² and X⁴ each independently represent a carbon atom or a nitrogen atom, one or more selected from X¹, X² and X⁴ represents a nitrogen atom; R⁴¹, R⁴², R⁴³, R⁴⁴, R⁴⁵ and R⁴⁶ each independently represent a hydrogen atom or a substituent; X⁹⁴ and X⁹⁵ each independently represent a carbon atom or a nitrogen atom; at least one of X⁹⁴ and X⁹⁵ represents a carbon atom; R⁹³ represents a hydrogen atom or a substituent; and L represents a single bond or a divalent linking group.
< 7 > The organic electroluminescence element according to any one of < 1 > to < 6 >, wherein the light emitting layer contains a metal complex compound containing a polydentate ligand having a partial structure represented by General Formula (2), at least one of platinum complex compounds containing a tetradentate ligand represented by General Formula (15a-3), and at least one host material.
< 8 > The organic electroluminescence element according to < 7 >, wherein the at least one host material is hole transportable.
< 9 > The organic electroluminescence element according to any one of < 1 > to < 8 >, wherein the nitrogen-containing heterocyclic derivative functions as at least one of an electron injection material and an electron transporting material.
< 10 > The organic electroluminescence element according to any one of < 1 > to < 9 >, wherein the layer containing the nitrogen-containing heterocyclic derivative contains a reducing dopant.
< 11 > The organic electroluminescence element according to < 10 >, wherein the reducing dopant is at least one selected from alkali metals, alkaline earth metals, rare earth metals, alkali metal oxides, alkali metal halides, alkali earth metal oxides, alkali earth metal halides, rare earth metal oxides, rare earth metal halides, alkali metal organic complexes, alkali earth metal organic complexes, and rare earth metal organic complexes.

The present invention can solve conventional problems and provide an organic electroluminescence element capable of reducing driving voltage and maintaining high light emission efficiency.

Brief Description of Drawings

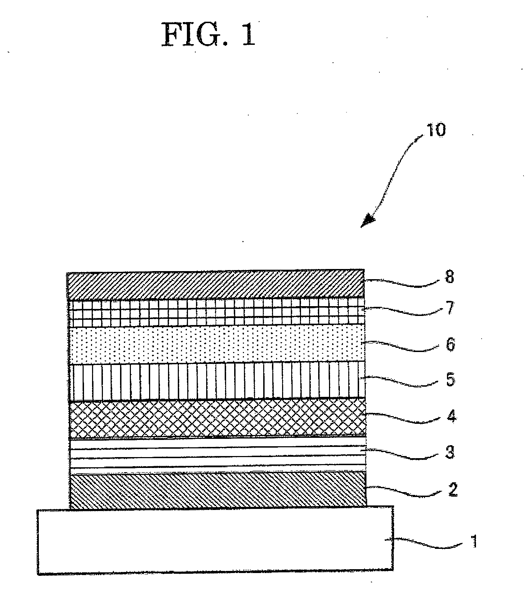

FIG. 1 is a schematic diagram illustrating one example of a layer configuration of an organic electroluminescence element according to the present invention.

### Description of Embodiments

### (Organic Electroluminescence Element)

The organic electroluminescence element of the present invention includes at least one organic layer including a light emitting layer, between an anode and a cathode, wherein at least one layer of the at least one organic layer contains at least one selected from specific nitrogen-containing heterocyclic derivatives, and at least one layer of the at least one organic layer contains an electron-transporting phosphorous light emitting material.

### < Nitrogen-containing Heterocyclic Derivative >

The nitrogen-containing heterocyclic derivative contains at least one selected from nitrogen-contaiing heterocyclic derivatives represented by General Formula (1): 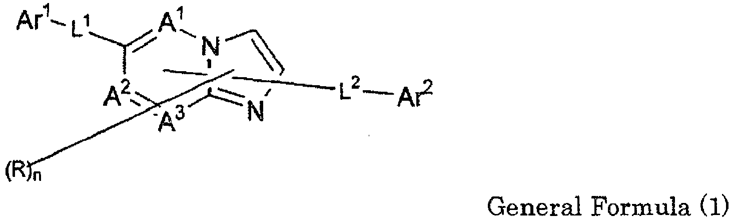 where A¹ to A³ each independently represent a nitrogen atom or a carbon atom, Ar¹ represents a substituted or unsubstituted aryl group having nucleus carbon atoms of 6 to 60 or a substituted or unsubstituted heteroaryl group having nucleus carbon atoms of 3 to 60, Ar² represents a hydrogen atom, a substituted or unsubstituted aryl group having nucleus carbon atoms of 6 to 60, a substituted or unsubstituted heteroaryl group having nucleus carbon atoms of 3 to 60, a substituted or unsubstituted alkyl group having 1 to 20 carbon atoms or a substituted or unsubstituted alkoxy group having 1 to 20 carbon atoms, wherein one of Ar¹ and Ar² is a substituted or unsubstituted condensed ring group having 10 to 60 nucleus carbon atoms or a substituted or unsubstituted monohetero condensed ring group having 3 to 60 nucleus carbon atoms; L¹ and L² each independently represent a single bond, a substituted or unsubstituted arylene group having 6 to 60 nucleus carbon atoms, a substituted or unsubstituted heteroarylene group having 3 to 60 nucleus carbon atoms or a substituted or unsubstituted fluorenylene group; R represents a hydrogen atoms, a substituted or unsubstituted aryl group having 6 to 60 nucleus carbon atoms, a substituted or unsubstituted heteroaryl group having nucleus carbon atoms of 3 to 60, a substituted or unsubstituted alkyl group having 1 to 20 carbon atoms or a substituted or unsubstituted alkoxy group having 1 to 20 carbon atoms; and n is an integer of 0 to 5, when n is 2 or greater, a plurality of Rs may be different from or identical to each other, and adjacent R groups among the plurality of Rs may be bonded to form a carbocyclic aliphatic ring or a carbocyclic aromatic ring.

The nitrogen-containing heterocyclic derivative represented by General Formula (1) is preferably a nitrogen-containing heterocyclic derivative represented by General Formula (3) below. 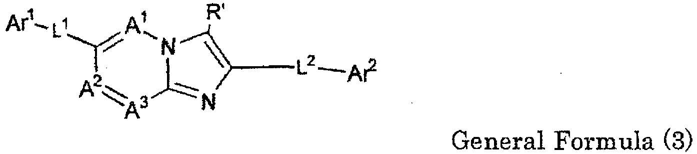 where A¹ to A³ each independently represent a nitrogen atom or a carbon atom, Ar¹ represents a substituted or unsubstituted aryl group having nucleus carbon atoms of 6 to 60 or a substituted or unsubstituted heteroaryl group having nucleus carbon atoms of 3 to 60, Ar² represents a hydrogen atom, a substituted or unsubstituted aryl group having nucleus carbon atoms of 6 to 60, a substituted or unsubstituted heteroaryl group having nucleus carbon atoms of 3 to 60, a substituted or unsubstituted alkyl group having 1 to 20 carbon atoms or a substituted or unsubstituted alkoxy group having 1 to 20 carbon atoms, wherein one of Ar¹ and Ar² is a substituted or unsubstituted condensed ring group having nucleus carbon atoms of 10 to 60 or a substituted or unsubstituted monohetero condensed ring group having nucleus carbon atoms of 3 to 60; L¹ and L² each independently represent a single bond, a substituted or unsubstituted arylene group having 6 to 60 nucleus carbon atoms, a substituted or unsubstituted heteroarylene group having 3 to 60 nucleus carbon atoms or a substituted or unsubstituted fluorenylene group; and R' represents a hydrogen atom, a substituted or unsubstituted aryl group having 6 to 60 nucleus carbon atoms, a substituted or unsubstituted heteroaryl group having 3 to 60 nucleus carbon atoms, a substituted or unsubstituted alkyl group having 1 to 20 carbon atoms or a substituted or unsubstituted alkoxy group having 1 to 20 carbon atoms.

The nitrogen-containing heterocyclic derivative represented by General Formula (3) is preferably a nitrogen-containing heterocyclic derivative represented by General Formula (4) below. 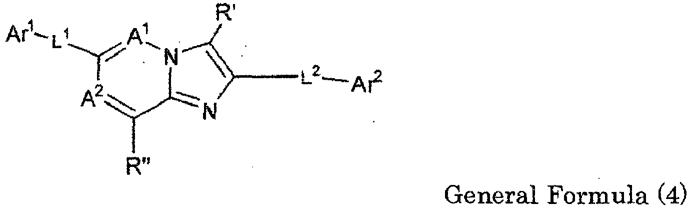 where A¹ and A² each independently represent a nitrogen atom or a carbon atom, Ar¹ represents a substituted or unsubstituted aryl group having nucleus carbon atoms of 6 to 60 or a substituted or unsubstituted heteroaryl group having nucleus carbon atoms of 3 to 60, Ar² represents a hydrogen atom, a substituted or unsubstituted aryl group having nucleus carbon atoms of 6 to 60, a substituted or unsubstituted heteroaryl group having nucleus carbon atoms of 3 to 60, a substituted or unsubstituted alkyl group having 1 to 20 carbon atoms or a substituted or unsubstituted alkoxy group having 1 to 20 carbon atoms, wherein one of Ar¹ and Ar² is a substituted or unsubstituted condensed ring group having 10 to 60 nucleus carbon atoms or a substituted or unsubstituted monohetero condensed ring group having 3 to 60 nucleus carbon atoms.

L¹ and L² each independently represent a single bond, a substituted or unsubstituted arylene group having 6 to 60 nucleus carbon atoms, a substituted or unsubstituted heteroarylene group having 3 to 60 nucleus carbon atoms or a substituted or unsubstituted fluorenylene group.

R' and R" each independently represent a hydrogen atom, a substituted or unsubstituted aryl group having 6 to 60 nucleus carbon atoms, a substituted or unsubstituted heteroaryl group having 3 to 60 nucleus carbon atoms, a substituted or unsubstituted alkyl group having 1 to 20 carbon atoms or a substituted or unsubstituted alkoxy group having 1 to 20 carbon atoms, and R' and R" may be different from or identical to each other.

In the nitrogen-containing heterocyclic derivative represented by any one of General Formulae (1), (3) and (4), at least one of L¹ and L² is selected from groups each independently represented by Structural Formulae below.

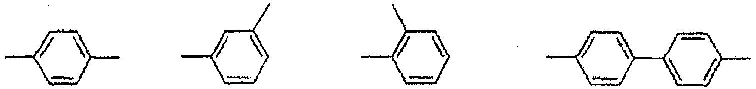

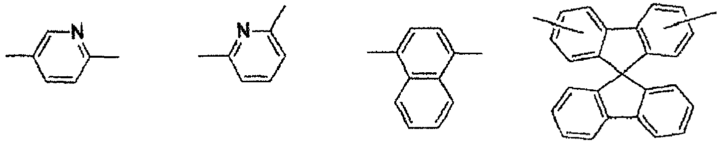

In the nitrogen-containing heterocyclic derivative represented by any one of General Formulae (1), (3) and (4), Ar¹ is a group represented by any one of General Formulae (5) to (14) below: 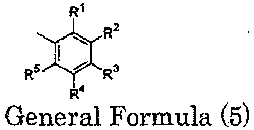 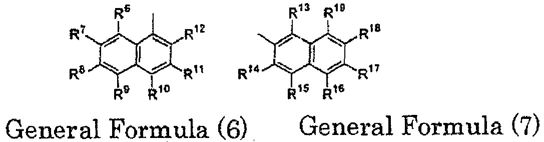 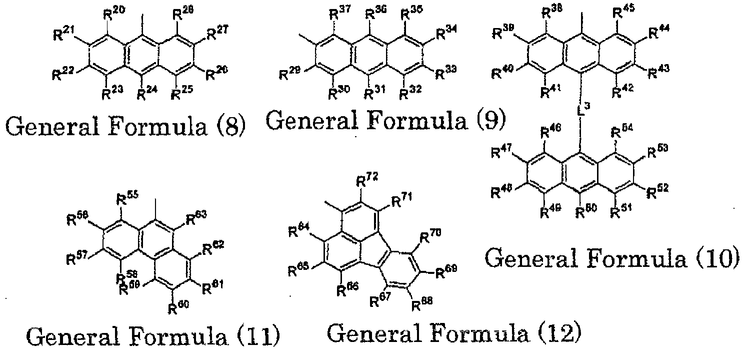 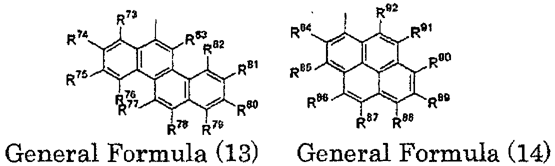 where R¹ to R⁹² each independently represent a hydrogen atom, a halogen atom, a substituted or unsubstituted alkyl group having 1 to 20 carbon atoms, a substituted or unsubstituted alkoxy group having 1 to 20 carbon atoms, a substituted or unsubstituted aryloxy group having 6 to 40 nucleus carbon atoms, a substituted or unsubstituted diarylamino group having 12 to 80 nucleus carbon atoms, a substituted or unsubstituted aryl group having 6 to 40 nucleus carbon atoms, a substituted or unsubstituted heteroaryl group having 3 to 40 nucleus carbon atoms, or a substituted or unsubstituted diarylaminoaryl group having 18 to 120 nucleus carbon atoms; and L³ represents a single bond or a substituent represented by any one of Structural Formulae below:

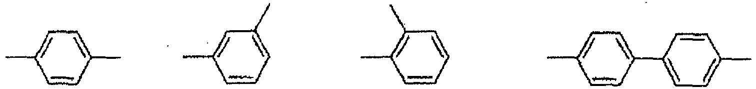

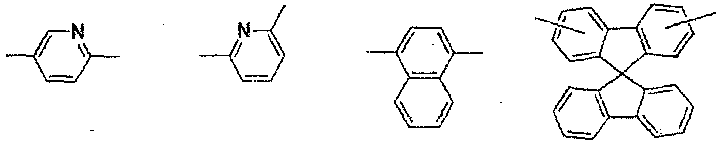

Specific examples of the nitrogen-containing heterocyclic derivative that can be used in the present invention include the following compounds, but not limited thereto.

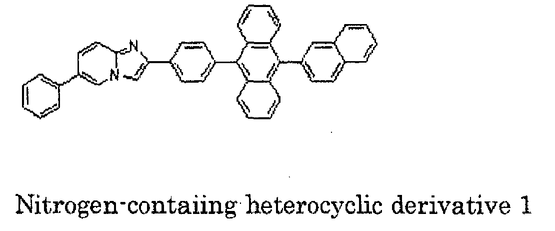

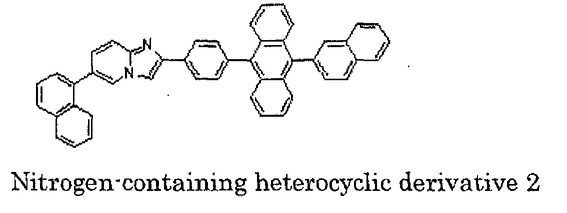

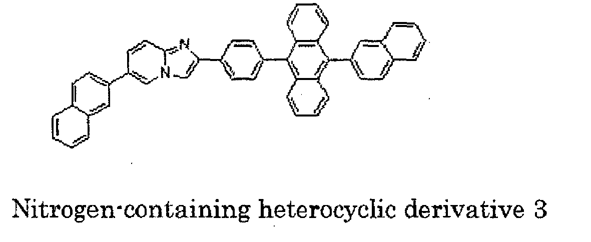

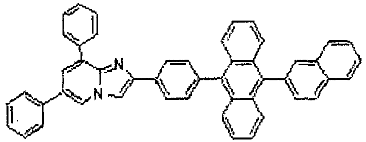

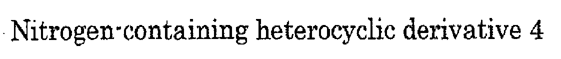

The nitrogen-containing heterocyclic derivative is preferably used as at least one of an electron injection material and an electron transporting material.

The nitrogen-containing heterocyclic derivative is contained in at least one organic layer, which is preferably at least one of an electron injection layer and an electron transporting layer.

The electron injection layer and the electron transporting layer are layers having a function to receive electrons from a cathode or cathode side and transport the electrons to the anode side.

The layers containing the nitrogen-containing heterocyclic derivative (the organic layer, electron injection layer, and electron transporting layer) preferably contain a reducing dopant.

The reducing dopant is preferably at least one selected from alkali metals, alkaline earth metals, rare earth metals, alkali metal oxides, alkali metal halides, alkali earth metal oxides, alkali earth metal halides, rare earth metal oxides, rare earth metal halides, alkali metal organic complexes, alkali earth metal organic complexes, and rare earth metal organic complexes.

The use amount of the reducing dopant varies depending on the type of the material, and it is, however, preferably 0.1% by mass to 99% by mass, more preferably 0.3% by mass to 80% by mass, and still more preferably 0.5% by mass to 50% by mass relative to the amount of the material for the electron transporting layer or electron injection layer.

The electron transporting layer and the electron injecting layer may be formed according to known methods. For example, these layers can be suitably formed by a vacuum deposition method, wet-process film forming method, MBE (Molecular Beam epitaxy) method, cluster ion beam method, molecule lamination method, LB method, printing method, transfer method and the like.

The thickness of the electron transporting layer preferably is preferably 1 nm to 200 nm, more preferably 1 nm to 100 nm, and still more preferably 1 nm to 50 nm.

The thickness of the electron injecting layer is preferably 1 nm to 200 nm, more preferably 1 nm to 100 nm, and still more preferably 1 nm to 50 nm.

### < Electron-Transporting Phosphorous Light Emitting Material>

The electron-transporting phosphorous light emitting material preferably contains an electron-transporting phosphorous light emitting material represented by the following General Formula (2).

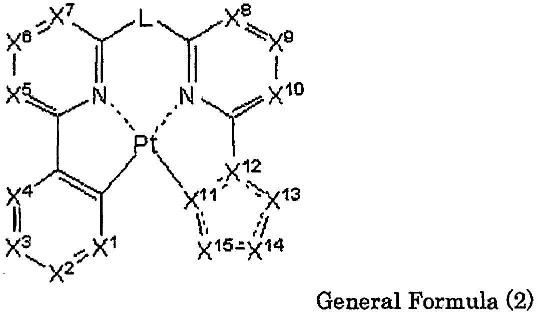

In General Formula (2), X¹, X², X³ and X⁴ each independently represent a carbon atom or a nitrogen atom, and one or more selected from X¹, X², X³ and X⁴ represent(s) a nitrogen atom; X⁵, X⁶, X⁷, X⁸, X⁹ and X¹⁰ each independently represent a carbon atom or a nitrogen atom; X¹¹ and X¹² each independently represent a carbon atom or a nitrogen atom; X¹³, X¹⁴ and X¹⁵ each independently represent a carbon atom, a nitrogen atom, an oxygen atom or a sulfur atom, the number of nitrogen atoms contained in a five-membered ring skeleton represented by any one of X¹¹, X¹², X¹³, X¹⁴ and X¹⁵ is 2 or smaller; and L represents a single bond or a divalent linking group.

The compound represented by General Formula (2) is preferably a compound represented by General Formula (15) below.

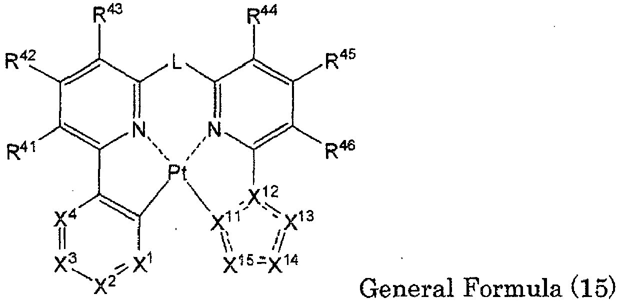

In General Formula (15), X¹, X², X³ and X⁴ each independently represent a carbon atom or a nitrogen atom and one or more selected from X¹, X², X³ and X⁴ represents or represent a nitrogen atom; R⁴¹, R⁴², R⁴³, R⁴⁴, R⁴⁵ and R⁴⁶ each independently represent a hydrogen atom or a substituent; X¹¹ and X¹² each independently represent a carbon atom or a nitrogen atom;, X¹³, X¹⁴ and X¹⁵ each independently represent a carbon atom, a nitrogen atom or a sulfur atom, the number of nitrogen atoms contained in a five-membered ring skeleton represented by any one of X¹¹, X¹², X¹³, X¹⁴ and X¹⁵ is 2 or smaller; and L represents a single bond or a divalent linking group.

The compound represented by General Formula (15) is preferably a compound represented by General formula (15a-1) below: 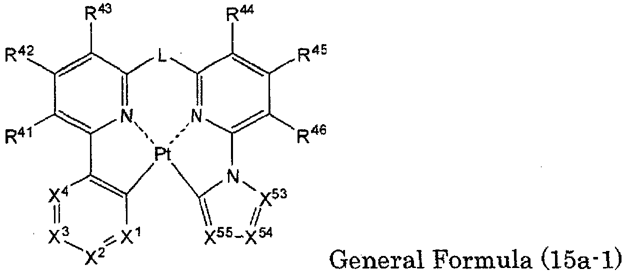 where X¹, X², X³ and X⁴ each independently represent a carbon atom or a nitrogen atom, one or more selected from X¹, X², X³ and X⁴ represents a nitrogen atom; R⁴¹, R⁴², R⁴³, R⁴⁴, R⁴⁵ and R⁴⁶ each independently represent a hydrogen atom or a substituent; X⁵³, X⁵⁴ and X⁵⁵ each independently represent a carbon atom or a nitrogen atom, and the number of nitrogen atoms contained in a five-membered ring skeleton containing X⁵³, X⁵⁴ and X⁵⁵ is 1 or 2; and L represents a single bond or a divalent linking group.

The compound represented by General Formula (15a-1) is preferably a compound represented by General Formula (15a-2) below.

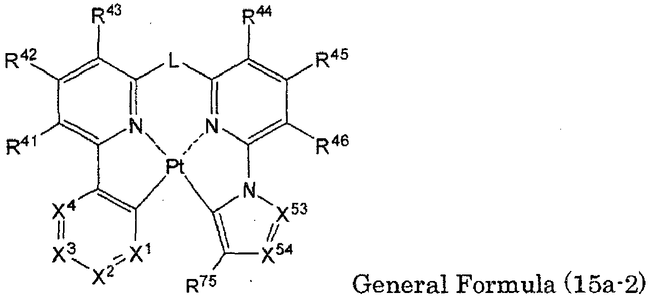

In General Formula (15a-2), X¹, X², X³ and X⁴ each independently represent a carbon atom or a nitrogen atom, one or more selected from X¹, X², X³ and X⁴ represents a nitrogen atom; R⁴¹, R⁴², R⁴³, R⁴⁴, R⁴⁵ and R⁴⁶ each independently represent a hydrogen atom or a substituent; X⁵³ and X⁵⁴ each independently represent a carbon atom or a nitrogen atom, and the number of nitrogen atoms contained in a five-membered ring skeleton containing X⁵³ and X⁵⁴ is 1 or 2; R⁷⁵ represents a hydrogen atom or a substituent; and L represents a single bond or a divalent linking group.

The compound represented by General Formula (15a-2) is preferably a compound represented by General Formula (15a-3) below.

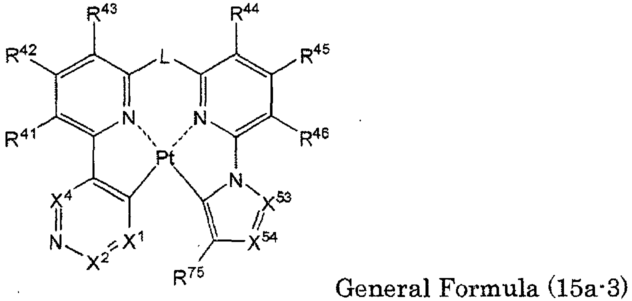

In General Formula (15a-3), X¹, X² and X⁴ each independently represent a carbon atom or a nitrogen atom; R⁴¹, R⁴², R⁴³, R⁴⁴, R⁴⁵ and R⁴⁶ each independently represent a hydrogen atom or a substituent; X⁵³ and X⁵⁴ each independently represent a carbon atom or a nitrogen atom, the number of nitrogen atoms contained in a 5-membered ring skeleton containing X⁵³ and X⁵⁴ is 1 or 2; R⁷⁵ represents a hydrogen atom or a substituent; and L represents a single bond or a divalent linking group.

The compound represented by General Formula (15) is preferably a compound represented by General Formula (15b-1) below.

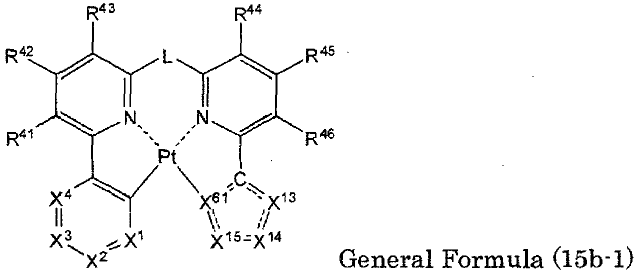

In General Formula (15b-1), X¹, X², X³ and X⁴ each independently represent a carbon atom or a nitrogen atom, one or more selected from X¹, X², X³ and X⁴ represents a nitrogen atom; R⁴¹, R⁴², R⁴³, R⁴⁴, R⁴⁵ and R⁴⁶ each independently represents a hydrogen atom or a substituent; X⁶¹ represents a carbon atom or a nitrogen atom; X¹³, X¹⁴ and X¹⁵ each independently represent a carbon atom, a nitrogen atom, an oxygen atom or a sulfur atom; the number of nitrogen atoms contained in a five-membered ring skeleton containing X⁶¹, a carbon atom, X¹³, X¹⁴ and X¹⁵ is 2 or less; and L represents a single bond or a divalent linking group.

The compound represented by General Formula (15b-1) is preferably a compound represented by General Formula (15b-2) below.

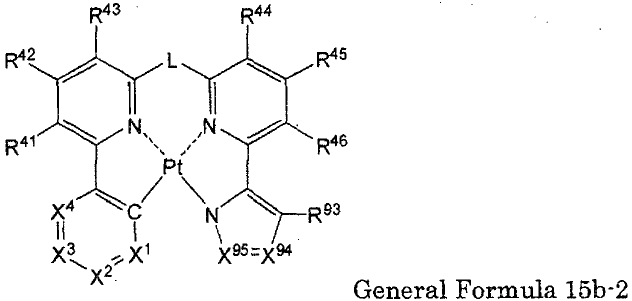

In General Formula (15b-2), X¹, X², X³ and X⁴ each independently represent a carbon atom or a nitrogen atom, one or more selected from X¹, X², X³ and X⁴ represents a nitrogen atom; R⁴¹, R⁴², R⁴³, R⁴⁴, R⁴⁵ and R⁴⁶ each independently represent a hydrogen atom or a substituent; X⁹⁴ and X⁹⁵ each independently represent a carbon atom or a nitrogen atom, and at least one of X⁹⁴ and X⁹⁵ represents a carbon atom; R⁹³ represents a hydrogen atom or a substituent; and L represents a single bond or a divalent linking group.

The compound represented by General Formula (15b-2) is preferably a compound represented by General Formula (15b-3) below.

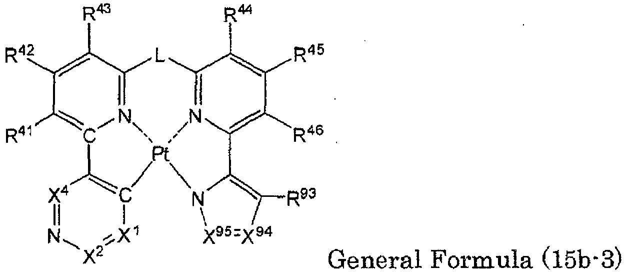

General Formula (15b-3), X¹, X² and X⁴ each independently represent a carbon atom or a nitrogen atom, one or more selected from X¹, X² and X⁴ represents a nitrogen atom; R⁴¹, R⁴², R⁴³, R⁴⁴, R⁴⁵ and R⁴⁶ each independently represent a hydrogen atom or a substituent; X⁹⁴ and X⁹⁵ each independently represent a carbon atom or a nitrogen atom; at least one of X⁹⁴ and X⁹⁵ represents a carbon atom; R⁹³ represents a hydrogen atom or a substituent; and L represents a single bond or a divalent linking group.

Specific examples of the electron-transporting phosphorous light emitting material usable in the present invention include the following compounds, but not limited thereto.

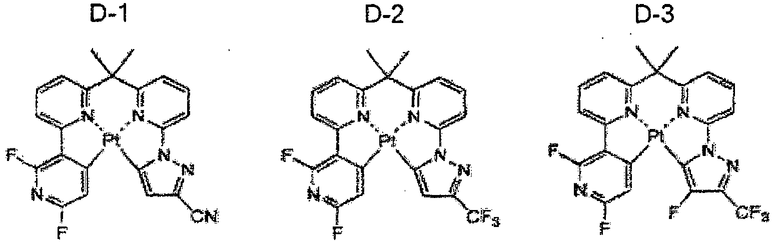

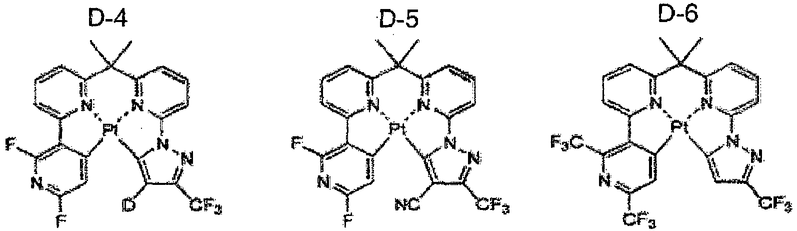

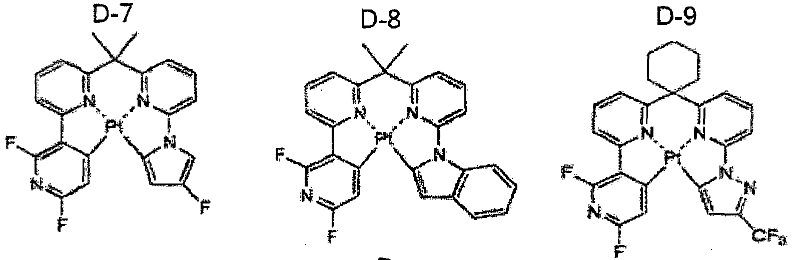

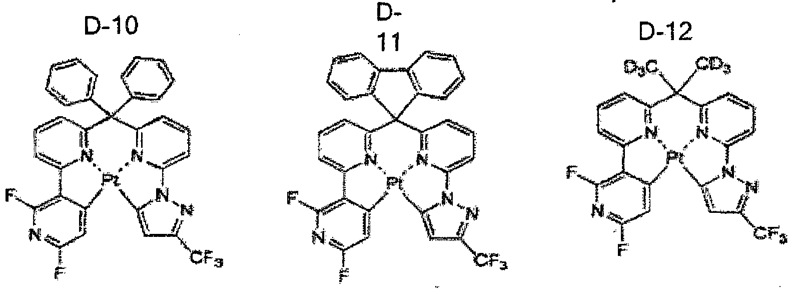

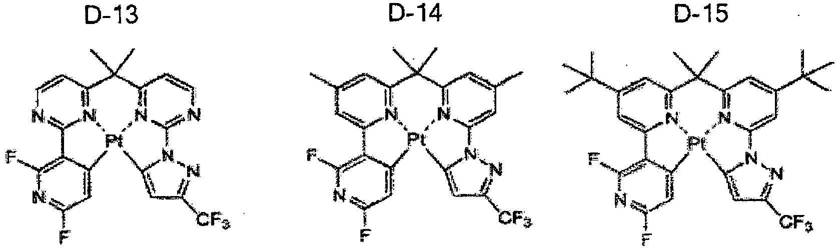

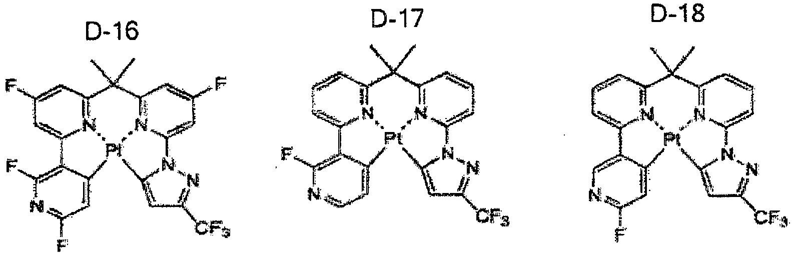

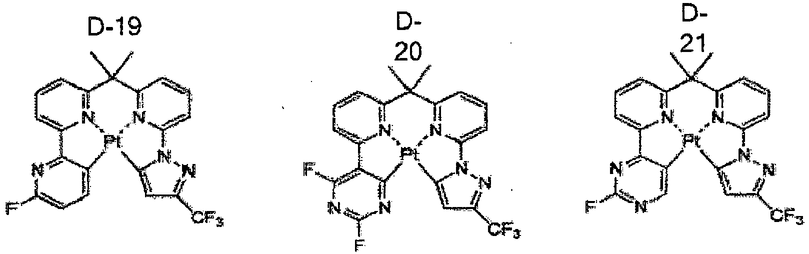

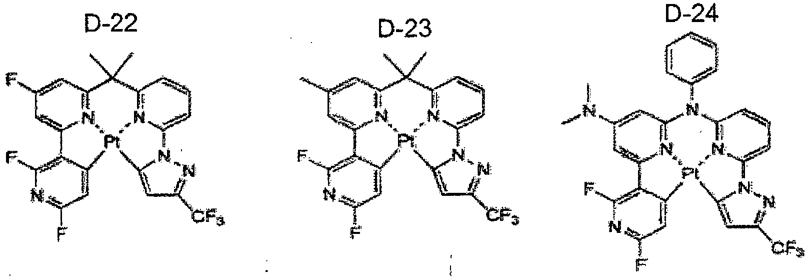

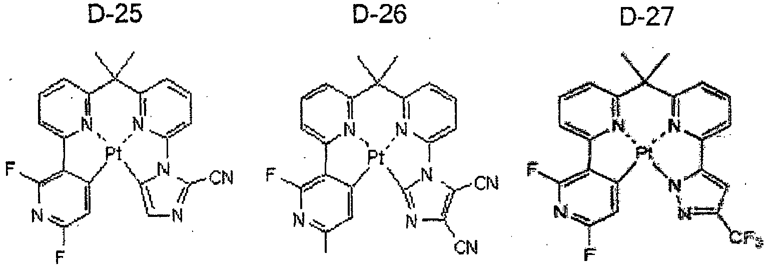

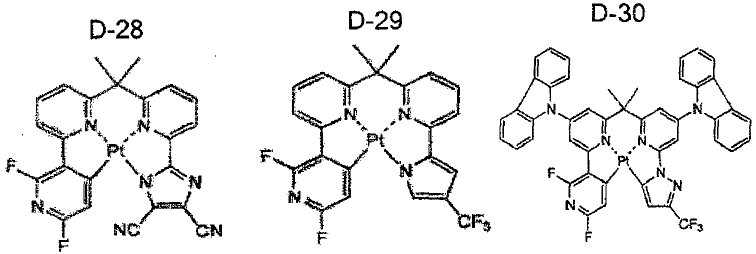

The metal complex compound containing a polydentate ligand having a partial structure represented by General Formula (2), and at least one of platinum complex compounds containing a tetradentate ligand represented by any one of General Formulae (15), (15a-1), (15a-2), (15a-3), (15b-1), (15b-2), and (15b-3) are contained in at least one layer of the organic layers, and preferably contained in the light emitting layer.

The metal complex compound containing a polydentate ligand having a partial structure represented by General Formula (2), at least one of platinum complex compounds containing a tetradentate ligand represented by any one of General Formulae (15), (15a-1), (15a-2), (15a-3), (15b-1), (15b-2), and (15b-3), and at least one host material are preferably contained in the light emitting layer, and additives such as adamantine may be contained therein.

In this case, the amount of the electron-transporting phosphorous light emitting material serving as the light emitting dopant is preferably 0.1% by mass to 90% by mass, more preferably 1% by mass to 50% by mass, and still more preferably 1% by mass to 25% by mass.

As the host material, both an electron transporting host and a hole-transporting host are preferably used, and these hosts may be used in combination.

### < Electron Transporting Host Material >

The electron transporting host material used in the present invention preferably has an electron affinity Ea, from the viewpoint of improvement of durability and reduction in driving voltage, of 2.5 eV to 3.5 eV, more preferably 2.6 eV to 3.4 eV, particularly preferably 2.8 eV to 3.3 eV, and preferably has an ionization potential Ip, from the viewpoint of improvement of durability and reduction in driving voltage, of 5.7 eV to 7.5 eV, more preferably 5.8 eV to 7.0 eV, particularly preferably 5.9 eV to 6.5 eV.

The lowest triplet excitation energy value (hereinbelow, referred to as T1) of the electron transporting host material is preferably 2.2eV to 3.7eV, more preferably 2.4eV to 3.7eV, and most preferably 2.4eV to 3.4eV.

Specific examples of such electron transporting hosts include pyridine, pyrimidine, triazine, imidazole, pyrazole, triazole, oxazole, oxadiazole, fluorenone, anthraquinodimethane, anthrone, diphenylquinone, thiopyrandioxide, carbodiimide, fluorenylidenemethane, distyrylpyrazine, fluorine-substituted aromatic compounds, heterocyclic tetracarboxylic anhydrides of naphthalene, perylene or the like, phthalocyanine, derivatives thereof (which may form a condensed ring with another ring), and a variety of metal complexes typified by metal complexes of 8-quinolinol derivatives, metal phthalocyanine, and metal complexes having benzoxazole or benzothiazole as the ligand.

Preferred examples of the electron transporting hosts are metal complexes, azole derivatives (benzimidazole derivatives, imidazopyridine derivatives etc.), and azine derivatives (pyridine derivatives, pyrimidine derivatives, triazine derivatives etc.). Among these, more preferred are metal complex compounds, from the viewpoint of durability. As the metal complex compound, a metal complex containing a ligand having at least one nitrogen atom, oxygen atom, or sulfur atom to be coordinated with the metal is more preferable.

Although a metal ion in the metal complex is not particularly limited, a beryllium ion, a magnesium ion, an aluminum ion, a gallium ion, a zinc ion, an indium ion, a tin ion, a platinum ion, or a palladium ion is preferred; more preferred is a beryllium ion, an aluminum ion, a gallium ion, a zinc ion, a platinum ion, or a palladium ion; and further preferred is an aluminum ion, a zinc ion, a platinum ion or a palladium ion.

Although there are a variety of well-known ligands to be contained in the above-described metal complexes, examples thereof include ligands described in "Photochemistry and Photophysics of Coordination Compounds" authored by H. Yersin, published by Springer-Verlag Co. in 1987; " YUHKI KINZOKU KAGAKU-KISO TO OUYOU (Organometallic Chemistry--Fundamental and Application--)" authored by Akio Yamamoto, published by Shokabo Publishing Co., Ltd. in 1982; and the like.
As the ligands, preferred are nitrogen-containing heterocyclic ligands (preferably having 1 to 30 carbon atoms, more preferably having 2 to 20 carbon atoms, particularly preferably having 3 to 15 carbon atoms). The ligands may be monodentate ligands or bidentate or higher ligands, but are preferably from bidentate ligands to hexadentate ligands, and mixed ligands of a monodentate ligand with a bidentate to hexadentate ligand are also preferable.

Specific examples of the ligands include azine ligands (e.g. pyridine ligands, bipyridyl ligands, terpyridine ligands, etc.); hydroxyphenylazole ligands (e.g. hydroxyphenylbenzimidazole ligands, hydroxyphenylbenzoxazole ligands, hydroxyphenylimidazole ligands, hydroxyphenylimidazopyridine ligands, etc.); alkoxy ligands (e.g. methoxy, ethoxy, butoxy and 2-ethylhexyloxy ligands, and these ligands preferably have 1 to 30 carbon atoms, more preferably have 1 to 20 carbon atoms, particularly preferably have 1 to 10 carbon atoms); aryloxy ligands (e.g. phenyloxy, 1-naphthyloxy, 2-naphthyloxy, 2,4,6-trimethylphenyloxy, and 4-biphenyloxy ligands, and these ligands preferably have 6 to 30 carbon atoms, more preferably have 6 to 20 carbon atoms, particularly preferably have 6 to 12); heteroaryloxy ligands (e.g. pyridyloxy, pyrazyloxy, pyrimidyloxy, quinolyloxy ligands and the like, and those having preferably 1 to 30 carbon atoms, more preferably 1 to 20 carbon atoms, and particularly preferably 1 to 12 carbon atoms); alkylthio ligands (e.g. methylthio, ethylthio ligands and the like, and those having preferably 1 to 30 carbon atoms, more preferably 1 to 20 carbon atoms, and particularly preferably 1 to 12 carbon atoms); arylthio ligands (e.g. phenylthio ligands and the like, and those having preferably 6 to 30 carbon atoms, more preferably 6 to 20 carbon atoms, and particularly preferably 6 to 12 carbon atoms); heteroarylthio ligands (e.g. pyridylthio, 2-benzimidazolylthio, 2-benzoxazolylthio, 2-benzothiazolylthio ligands and the like, and those having preferably 1 to 30 carbon atoms, more preferably 1 to 20 carbon atoms, and particularly preferably 1 to 12 carbon atoms); siloxy ligands (e.g. a triphenylsiloxy group, a triethoxysiloxy group, a triisopropylsiloxy group and the like, and those having preferably 1 to 30 carbon atoms, more preferably 3 to 25 carbon atoms, and particularly preferably 6 to 20 carbon atoms); aromatic hydrocarbon anion ligands (e.g. a phenyl anion, a naphthyl anion, an anthranyl anion and the like, and those having preferably 6 to 30 carbon atoms, more preferably 6 to 25 carbon atoms, and particularly preferably 6 to 20 carbon atoms); aromatic heterocyclic anion ligands (e.g. a pyrrole anion, a pyrazole anion, a triazole anion, an oxazole anion, a benzoxazole anion, a thiazole anion, a benzothiazole anion, a thiophene anion, a benzothiophene anion and the like, and those having preferably 1 to 30 carbon atoms, more preferably 2 to 25 carbon atoms, and particularly preferably 2 to 20 carbon atoms); and indolenine anion ligands. Among these, nitrogen-containing heterocyclic ligands, aryloxy ligands, heteroaryloxy groups, siloxy ligands are preferable. Nitrogen-containing aromatic heterocyclic ligands, aryloxy ligands, siloxy ligands, aromatic hydrocarbon anion ligands, and aromatic heterocyclic anion ligands are more preferable.

Examples of the metal complex electron transporting hosts include compounds described, for example, in Japanese Patent Application Laid-Open (JP-A) Nos. 2002-235076, 2004-214179, 2004-221062, 2004-221065, 2004-221068, and 2004-327313.

Specific examples of such electron transporting host materials include the following materials, but not limited thereto.

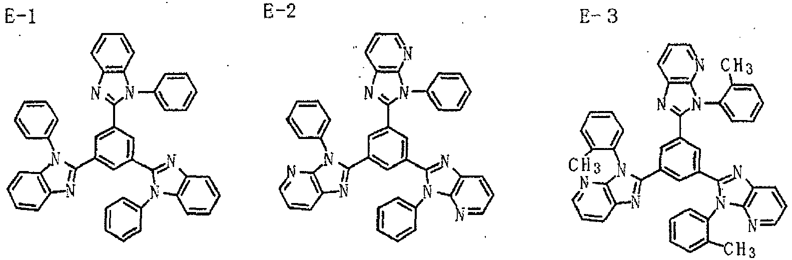

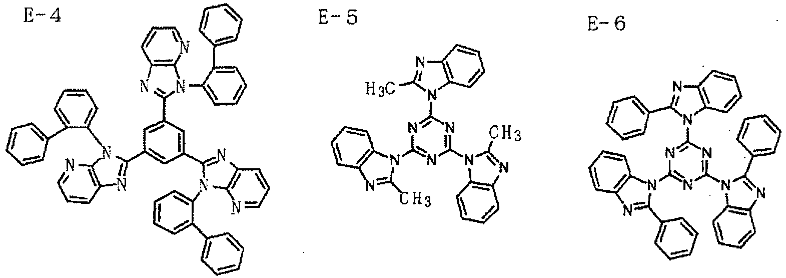

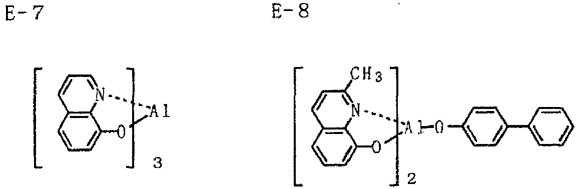

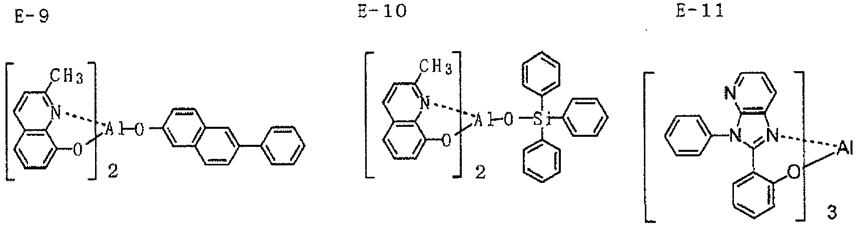

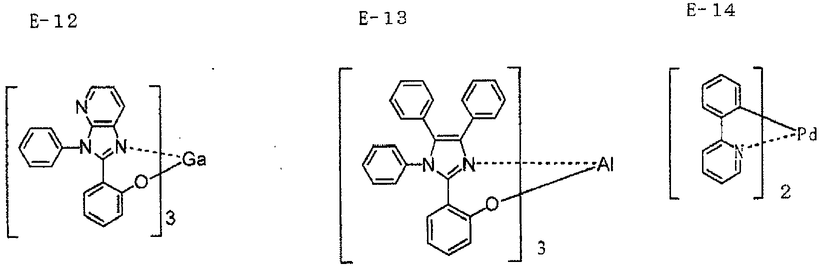

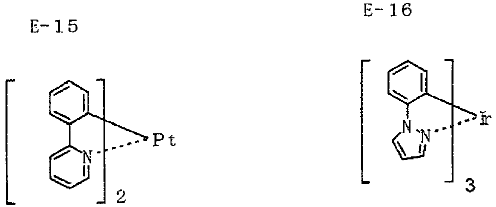

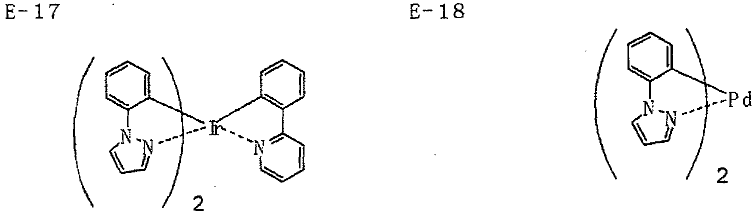

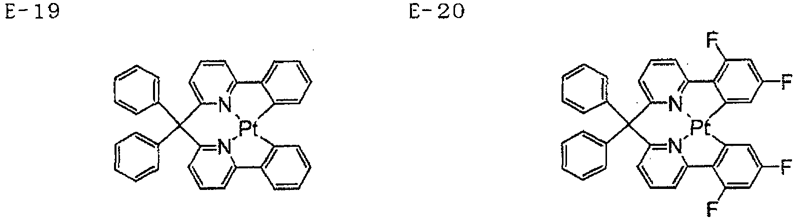

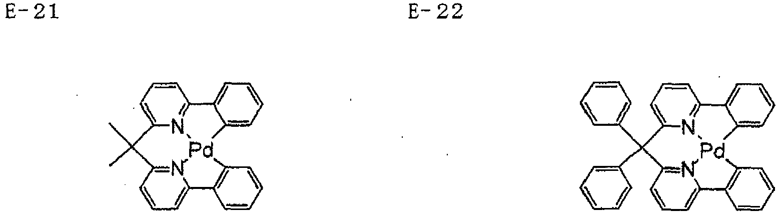

### < Hole Transporting Host Material >

The hole transporting host material used in the light emitting layer of the present invention preferably has an ionization potential Ip, from the viewpoint of improvement of durability and reduction in driving voltage, of 5.1eV to 6.4eV, more preferably 5.4eV to 6.2eV, and still more preferably 5.6eV to 6.0eV. From the viewpoint of improvement of durability and reduction in driving voltage, the electron affinity Ea of the host transporting host material is preferably 1.2eV to 3.1eV, more preferably 1.4eV to 3.0eV, and still more preferably 1.8eV, to 2.8eV.

The lowest triplet excitation energy value (hereinbelow, referred to as T1) of the hole transporting host material is preferably 2.2eV to 3.7eV, more preferably 2.4eV to 3.7eV, and most preferably 2.4eV to 3.4eV

Examples of the hole transporting host material include pyrrole, indole, carbazole, azaindole, azacarbazole, triazole, oxazole, oxadiazole, pyrazole, imidazole, thiophene, polyarylalkane, pyrazoline, pyrazolone, phenylenediamine, arylamine, amino-substituted chalcone, styrylanthracene, fluorenone, hydrazone, stilbene, silazane, aromatic tertiary amine compounds, styrylamine compounds, aromatic dimethylidine compounds, porphyrin compounds, polysilane compounds, poly(N-vinylcarbazole), aniline copolymers, electrically conductive high-molecular oligomers such as thiophene oligomers, polythiophenes and the like, organic silanes, carbon films, derivatives thereof.

Among these, indole derivatives, carbazole derivatives, azaindole derivatives, azacarbazole derivatives, aromatic tertiary amine compounds, and thiophene derivatives are preferred, with compounds each having a plurality of indole skeletons, carbazole skeletons, azaindole skeletons, azacarbazole skeletons or aromatic tertiary amine skeletons in the molecule being particularly preferable.

In addition, in the present invention, a host material in which part or all of hydrogen atoms are substituted with heavy hydrogen atoms may be used (Japanese Patent Application Laid-Open (JP-A) No. 2008-126130, Japanese Patent Application Publication (JP-B) No. 2004-515506).

Specific examples of compounds as such hole transporting host materials include the following compounds, but not limited thereto.

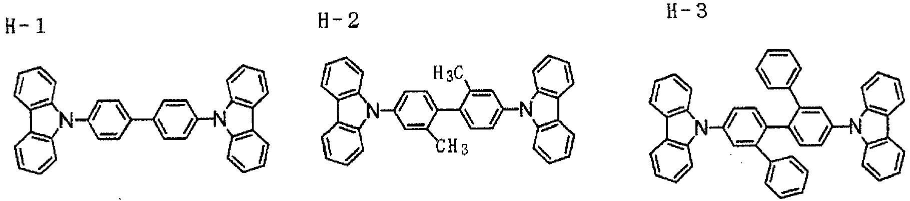

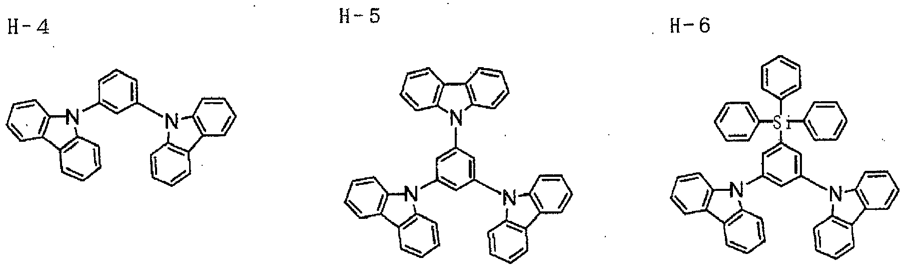

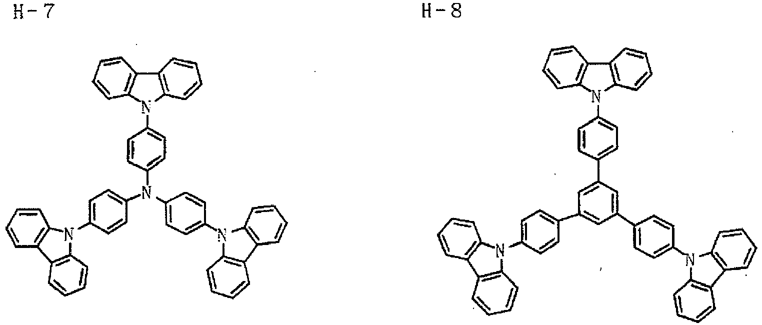

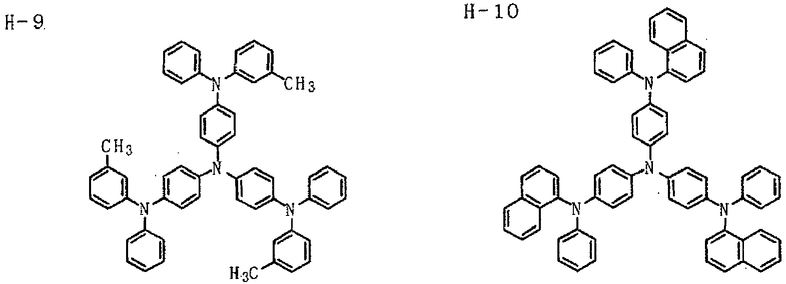

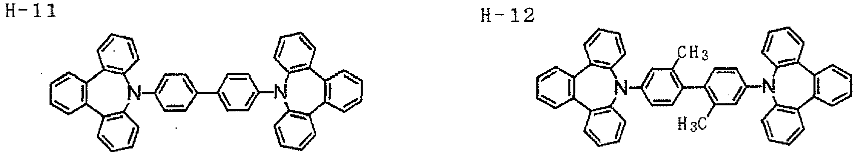

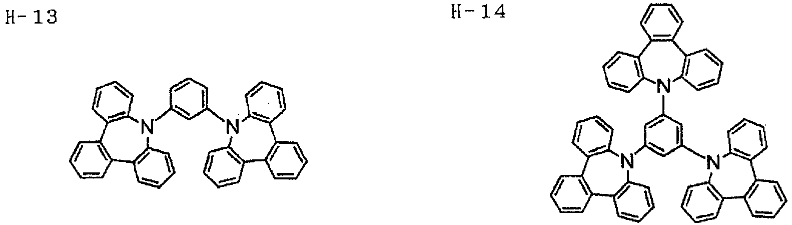

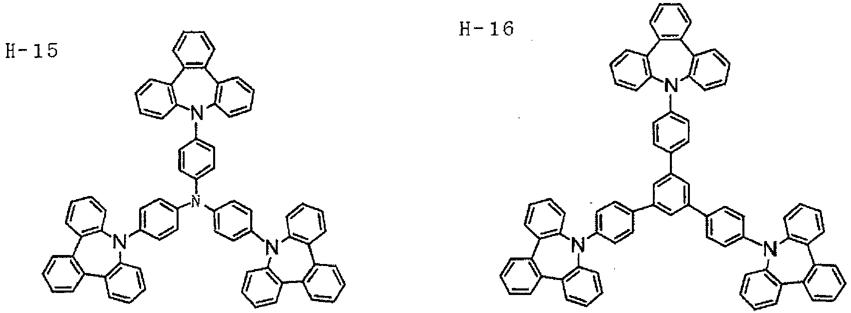

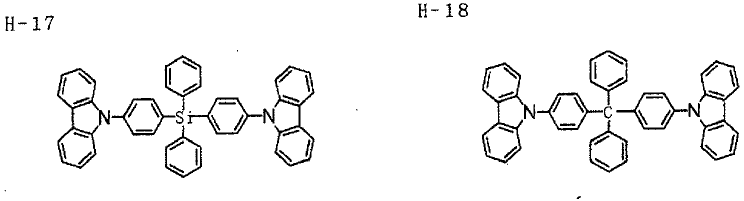

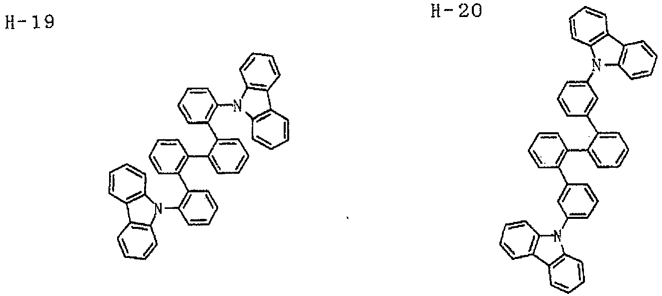

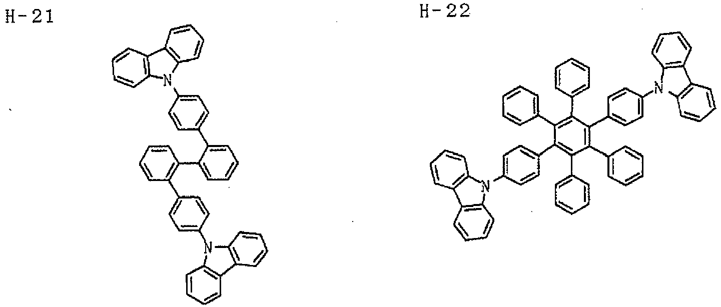

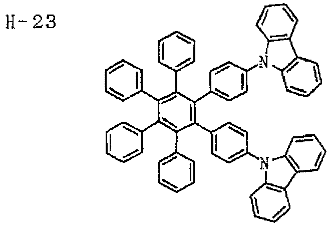

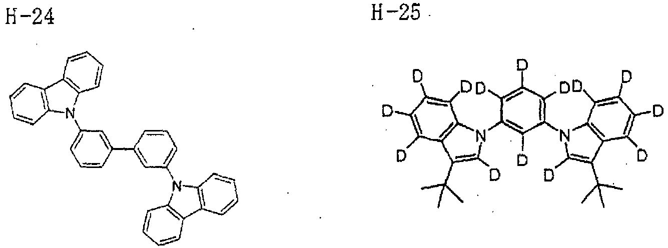

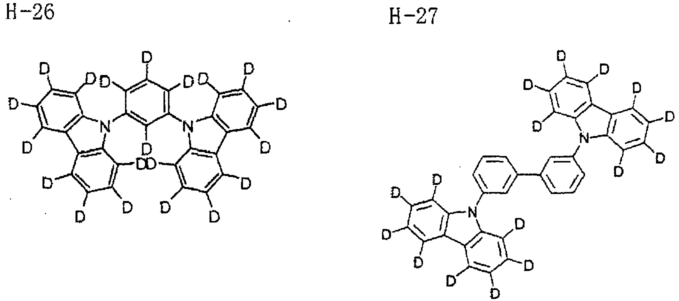

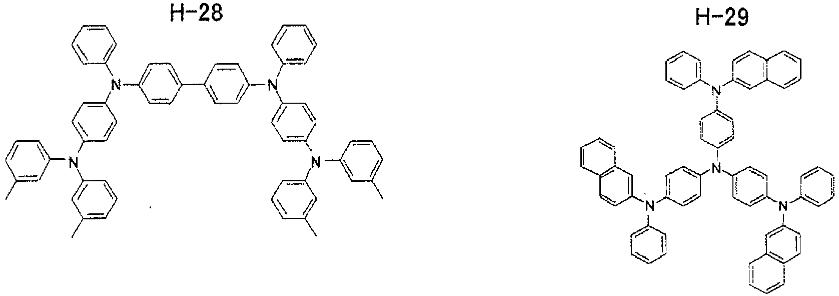

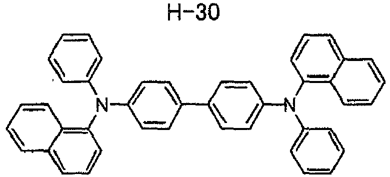

The light emitting layer is a layer having functions to receive, at the time of electric field application, holes from the anode, hole injecting layer or hole transporting layer, and to receive electrons from the cathode, electron injection layer or electron transporting layer, and offer the field of recombination of holes and electrons to emit light.

The light emitting layer can be formed according to a known method, without any particular limitation. The light emitting layer can be appropriately formed, for example, by a dry-process film formation method such as a vapor deposition method and a sputtering method; a wet-process coating method, a transcription method, a printing method, an inkjet method, or the like.

The thickness of the light emitting layer is not particularly limited and may be suitably selected in accordance with the intended use. It is preferably 2 nm to 500 nm, and from the viewpoint of improving the external quantam efficiency, it is more preferably 3 nm to 200 nm, and still more preferably 10 nm to 200 nm. The light emitting layer may be formed of a single layer or two or more layers in which each layer may emit light of a different color.

The organic electroluminescence element of the present invention includes an organic layer including a light emitting layer, between an anode and a cathode.

The organic layer includes at elast the light emitting layer, includes an electron transporting layer, and an electron injection layer, and may include, as required, a hole injection layer, a hole transporting layer, a hole blocking layer, an electron blocking layer, and the like.

### < Electron Injection Layer and Electron Transporting Layer >

The electron injection layer and the electron transporting layer are layers having functions for receiving electrons from a cathode or from a cathode side, and transporting electrons to an anode side.

The electron transporting layer is formed of materials of the electron transporting host material, the electron donating dopant, and the like.

The thickness of the electron injection layer and the electron transporting layer is not particularly limited and may be suitably selected in accordance with the intended use. From the viewpoint of reducing driving voltage, it is preferably 500 nm or less.

The thickness of the electron transporting layer is preferably from 1 nm to 500 nan, more preferably from 5 nm to 200 nm, and still more preferably from 10 nm to 100 nm. The thickness of the electron injection layer is preferably from 0.1 nm to 200 nm, more preferably from 0.2 nm to 100 nm, and still more preferably from 0.5 nm to 50 nm.

The electron injection layer and the electron transporting layer may take a single layer structure containing one or two or more of materials, or a multilayer structure composed of plural layers of a homogeneous composition or a heterogeneous composition.

### < Hole Injection Layer and Hole Transporting Layer >

The hole injection layer and the hole transporting layer are layers functioning to receive holes from an anode or from an anode side and to transport the holes to a cathode side. The hole injection layer and the hole transporting layer may take a single layer structure or a multilayer structure composed of plural layers of a homogeneous composition or a heterogeneous composition. A hole injection material and a hole transporting material for use in these layers may be low-molecular weight compounds or high-molecular weight compounds.

The hole injection material or the hole transporting material is not particularly limited and may be suitably selected in accordance with the intended use. Examples thereof include pyrrole derivatives, carbazole derivatives, triazole derivatives, oxazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, styrylanthracene derivatives, fluorenone derivatives, hydrazone derivatives, stilbene derivatives, silazane derivatives, aromatic tertiary amine compounds, styrylamine compounds, aromatic dimethylidyne compounds, phthalocyanine compounds, porphyrin compounds, thiophene compounds, organic silane derivatives, and carbon. These materials may be used alone or in combination.

An electron-accepting dopant may be introduced into the hole injection layer or the hole transport layer.

As the electron-accepting dopant to be introduced into a hole injection layer or a hole transport layer, either or both of an inorganic compound or an organic compound may be used as long as the compound has electron accepting property and a property for oxidizing an organic compound.

The inorganic compound is not particularly limited and may be suitably selected in accordance with the intended use. Examples thereof include metal halides, such as iron (II) chloride, aluminum chloride, gallium chloride, indium chloride and antimony pentachloride, and metal oxides, such as vanadium pentaoxide, and molybdenum trioxide.

The organic compound is not particularly limited and may be suitably selected in accordance with the intended use. Examples thereof include compounds having a substituent such as a nitro group, a halogen, a cyano group, a trifluoromethyl group or the like; quinone compounds; acid anhydride compounds; fullerenes

These electron accepting dopants may be used alone or in combination. The use amount of the electron accepting dopant varies depending on the type of the material. It is, however, preferably 0.01% by mass to 50% by mass, more preferably 0.05% by mass to 20% by mass, and still more preferably 0.1% by mass to 10% by mass relative to the amount of the hole transporting material or the hole injection material.

The hole injection layer and the hole transporting layer can be appropriately formed by a known method, for example, by a dry-process film formation method such as a vapor deposition method and a sputtering method; a wet-process coating method, a transcription method, a printing method, an injet method, or the like.

The thickness of the hole injection layer and the hole transporting layer is preferably 1 nm to 500 nm, more preferably 5 nm to 200 nm, and still more preferably 10 nm to 100 nm.

### < Hole Blocking Layer and Electron Blocking Layer >

The hole blocking layer is a layer having a function to prevent holes transported from the anode side to the light emitting layer from passing through the cathode side. The hole blocking layer is generally provided as an organic compound layer contiguous to the light emitting layer on the cathode side.

The electron blocking layer is a layer having a function to prevent electrons transported from the cathode side to the light emitting layer from passing through the anode side. The electron blocking layer is generally provided as an organic layer contiguous to the light emitting layer on the anode side.

Examples of a compound constituting the hole blocking layer include aluminum complexes such as BAlq, triazole derivatives, and phenanthroline derivatives such as BCP.

As a compound constituting the electron blocking layer, those described as the hole transporting materials can be utilized.

The electron blocking layer and the hole blocking layer may be formed by a known method, without any particular limitation. For example, the electron blocking layer and the hole blocking layer can be appropriately formed by a dry-process film formation method such as a vapor deposition method and a sputtering method; a wet-process coating method, a transcription method, a printing method, an inkjet method, or the like.

The thickness of the hole blocking layer and the electron blocking layer is preferably 1 nm to 200 nm, more preferably 1 nm to 50 nm, and still more preferably 3 nm to 10 nm. In addition, the hole blocking layer and the electron blocking layer may take a single layer structure containing one or two or more of the above-mentioned materials, or a multilayer structure composed of plural layers of a homogeneous composition or a heterogeneous composition.

### < Electrode >

The organic electroluminescence element of the present invention includes a pair of electrodes, that is, an anode and a cathode. In view of the characteristics of the organic electroluminescence element, at least one of the anode and the cathode is preferably transparent. Typically, the anode is sufficient to have a function as an electrode supplying holes to the organic compound layer, and the cathode is suffient to have a function as an electrode injecting electrons to the organic compound layer.

The electrons are not particularly limited as to the shape, structure, size and the like, and may be suitably selected from known electron materials according to the application and intended use of the organic electroluminescence element.

As materials constituting the electrodes, a metal, an alloy, a metal oxide, a conductive compound, or mixture thereof etc. are preferably exemplified.

### - Anode -

Examples of materials constituting the anode include tin oxides doped with antimony, fluorine, etc. (ATO, FTO); electrically conductive metal oxides such as tin oxide, zinc oxide, indium oxide, indium tin oxide (ITO), and indium zinc oxide (IZO); metals such as gold, silver, chromium, and nickel; mixtures and laminates of these metals with electrically conductive metal oxides; inorganic electrically conductive materials such as copper iodide, and copper sulfide; organic electrically conductive materials such as polyaniline, polythiophene, and polypyrrole; and laminates of these organic electrically conductive materials with ITO, etc. Among these materials, preferred are electrically conductive metal oxides, and ITO is especially preferred from the viewpoint of productivity, high-conductivity, transparency and the like.

### - Cathode -

Examples of materials constituting the cathode include alkali metals (e.g. Li, Na, K, Cs, etc.), alkaline earth metals (e.g. Mg, Ca, etc.), and rare earth metals such as gold, silver, lead, aluminum, sodium-potassium alloy, lithium-aluminum alloy, magnesium-silver alloy, indium, and ytterbium. These materials may be used alone, however, from the viewpoint of simultaneous achievement of stability and electron injection properties, two or more materials can be preferably used in combination.

Among these, as the material constituting the cathode, alkali metals and alkaline earth metals are preferred in terms of the electron injecting property, and materials mainly containing aluminum are preferred for their excellent storage stability.

The materials mainly containing aluminum mean aluminum alone, alloys of aluminum with 0.01% by mass to 10% by mass of alkali metal or alkaline earth metal, or mixtures of these (e.g., lithium-aluminum alloy, magnesium-aluminum alloy, etc.).

The method of forming the electrodes is not particularly limited and may be formed according to a known method. Examples of the forming method include wet-process methods such as a printing method, and a coating method; physical methods such as sputtering and an ion-plating method, and chemical methods such as a CVD method and a plasma CVD method. Among these methods, in view of the applicability with a material constituting the electrodes, the electrodes can be formed on the substrate according to a suitably selected method. For example, when ITO is selected as a material for the anode, the anode can be formed by a direct-current or high-frequency sputtering method, a vacuum deposition method, an ion-plating method, or the like. When metal is selected as a material for the cathode, the cathode can be formed by sputting or or two or more metals simultaneously or sequentially.

Note that when patterning is performed in formation of the electrodes, the patterning of the electrodes may be carried out by chemical etching such as photo-lithography, may be carried out by physical etching with use of a laser, etc., may be carried out by vacuum vapor deposition or sputtering on a superposed mask, or a lift-off method or a printing method may be used.

### < Substrate >

The organic electroluminescence element of the present invention is preferably formed on a substrate, and may be provided in the form where the electrodes are directly contacted with the substrate or an intermediate layer is interposed between the electrodes and the substrate.

A material of the substrate is not particularly limited and may be suitably selected in accordance with the intended use.

Examples of the material of the substrate include inorganic materials, e.g., yttria stabilized zirconia (YSZ), and glass; and organic materials, such as polyester, e.g., polyethylene terephthalate, polybutylene phthalate, and polyethylene naphthalate; polystyrene, polycarbonate, polyether sulfone, polyallylate, polyimide, polycycloolefin, norbornene resin, and poly(chlorotrifluoroethylene).

The shape, structure, size etc. of the substrate are not particularly limited and may be suitably selected in accordance ith the application and intended use of the electroluminescence element. Generally, the substrate is preferably formed in a plate-shape. As the structure of the substrate, it may be a single structure or a multilayer structure, and may consist of a single member or may be formed of two or more members. The substrate may be transparent or opaque. When the substrate is transparent, it may be may be colorless and transparent, or may be colored and transparent.

The substrate can be provided with a moisture permeation preventing layer (a gas barrier layer) on its front surface or rear surface.

As the materials of the moisture permeation-preventing layer (the gas barrier layer), inorganic materials such as silicon nitride and silicon oxide are exemplified.

The moisture permeation-preventing layer (the gas barrier layer) can be formed, for example, by a high frequency sputtering method.

### - Protective Layer -

The organic electroluminescence element may be wholly protected by a protective layer.

The material contained in the protective layer is not particularly limited, as long as it has a function to prevent those accelerating deterioration of the organic electroluminescence element such as moisture and oxygen from entering the organic electroluminescence element, and may be suitably selected in accordance with the intended use. Examples of the material include metals such as In, Sn, Pb, Au, Cu, Ag, Al, Ti, and Ni; metal oxides such as MgO, SiO, SiO₂, Al₂O₃, GeO, NiO, CaO, BaO, Fe₂O₃, Y₂O₃, and TiO₂; metal nitrides such as SiNₓ, and SiNₓO_{y}; metal fluorides such as MgF₂, LiF, AlF3, and CaF₂; copolymers of dichloroethylene with polyethylene, polypropylene, polymethylmethacrylate, polyimide, polyurea, polytetrafluoroethylene, polychlorotrifluoroethylene, polychlorotrifluoroethylene, polydichlorodifluoroethylene, and/or chlorotrifluoroethylene; a copolymer obtained by copolymerization of tetrafluoroethylene with a monomer mixture containing at least one co-monomer, a fluorine-containing copolymer having a cyclic structure at its copolymer main chain, hydrophilic substances having a coefficient of water absorption of 1% or higher, and water-vaporproof substances having a coefficient of water absorption of 0.1% or lower.

The method of forming the protective layer is not particularly limited and may be suitably selected in accordance with the intended use. For example, there are exemplified a vacuum deposition method, sputtering method, reactive sputtering method, MBE (Molecular Beam epitaxy) method, cluster ion beam method, ion plating method, plasma polymerization method (high-frequency excited ion plating method), plasma CVD method, laser CVD method, thermal CVD method, gas-source CVD method, coating method, printing method, and transcription method.

### - Sealing Container -

The organic electroluminescence element of the present invention may be entirely sealed by a sealing container. Further, in a space between the sealing container and the organic electroluminescence element, a water-absorbing agent or an inactive liquid may be encapsulated.

The water-absorbing agent is not particularly limited and may be suitably selected in accordance with the intended use. Examples thereof include barium oxides, sodium oxides, potassium oxides, calcium oxides, sodium sulfate, calcium sulfate, magnesium sulfate, phosphorus pentoxide, calcium chloride, magnesium chloride, copper chloride, cesium fluoride, niobium fluoride, calcium bromide, vanadium bromide, molecular sieves, zeolite, and magnesium oxide.

The inactive liquid is not particularly limited and may be suitably selected in accordance with the intended use. Examples thereof include paraffins, fluid paraffins, fluorine solvents such as perfluoroalkane, perfluoroamine, and perfluoroether; chlorine solvents, and silicone oils.

### - Resin Sealing Layer -

In the organic electroluminescence element of the present invention, it is preferable to prevent degradation of properties of the organic electroluminescence element due to oxygen and moisture from atmosphere by providing a resin sealing layer.

The resin material of the resin sealing layer is not particularly limited and may be suitably selected in accordance with the intended use. Examples thereof include epoxy resins, fluorine-based resins, silicone-based resins, rubber-based resins, and ester-based resins. Among these materials, epoxy resins are particularly preferable from the viewpoint of the water-proof function.

The method of producing the resin sealing layer is not particularly limited and may be suitably selected in accordance with the intended use. Examples of the method include a method of applying a resin solution, a method of pressing or thermally pressing a resin sheet, and a dry-process polymerization method such as a vapor deposition method and sputtering.

### - Sealing Adhesive -

A sealing adhesive for use in the present invention has a function to prevent moisture and oxygen from entering the organic electroluminescence element from its distal ends thereof.

As materials for the sealing adhesive, the same materials for the resin sealing layer can be used. Among the materials, in view of prevention of moisture, preferred is an epoxy-based adhesive, and more preferred are a photocurable adhesive and a thermocurable adhesive.

Further, it is preferred to add a filler to the sealing adhesive. As a filler to be added to the sealing agent, inorganic materials such as SiO₂, SiO (silicon oxide), SiON (silicon oxynitride), SiN (silicone nitride) and the like are preferred. By adding a filler to the sealing agent, the viscosity of the sealing agent is increased, leading to improvements in process suitability and humidity resistance.

The sealing adhesive may contain a desiccating agent. As the desiccating agent, barium oxides, calcium oxides, strontium oxides are exemplified. The amount of the desiccating agent added to the sealing agent is preferably 0.01% by mass to 20% by mass, more preferably 0.05% by mass to 15% by mass. When the addition amount is less than 0.01% by mass, the effect of adding the desiccating agent is reduced. When the addition amount is more than 20% by mass, it is undesirably difficult to homogenously disperse the desiccating agent in the sealing adhesive.

In the present invention, the sealing adhesive in which he desiccating agent has been contained is applied in an optional amount by a dispenser or the like, and thereafter, a second substrate is superposed on the workpiece, followed by curing, to thereby the organic electroluminescence elopement can be sealed.

FIG. 1 is a schematic diagram illustrating one example of a layer configuration of the organic electroluminescence element of the present invention. An organic EL element 10 has a layer configuration where an anode 2 (e.g., ITO electrode) formed on a glass substrate 1, a hole injection layer 3, a hole transporting layer 4, a light emitting layer 5, an electron transporting layer 6, an electron injection layer 7, and a cathode 8 (e.g., Al-Li electrode) are laminated in this order. Note that the anode 2 (e.g., ITO electrode) and the cathode 8 (e.g., Al-Li electrode) are connected to each other via a power source.

### - Driving -

By the application of DC (if necessary, AC component may be contained) voltage (generally from 2 volts to 15 volts) between the anode and the cathode, or by the application of DC electric current, light emission of the organic electroluminescence element of the invention can be obtained.

The organic electroluminescence element of the present invention can be used for an active matrix through a thin film transistor (TFT). As a material for use in an active layer of the thin film transistor, an amorphous silicon, a high-temperature polysilicon, a low-temperature polysilicon, a microcrystal silicon, an oxide semiconductor, an organic semiconductor, a carbon nanotube or the like can be used.

In the organic electroluminescence element of the present invention, thin film transistors described, for example, in WO2005/088726, Japanese Patent Application Laid-Open (JP-A) No. 2006-165529, U.S. Patent Application No. 2008/0237598A1 etc. can be used.

The organic electroluminescence element of the present invention can be improved in the efficiency of extraction of light by various known contrivances, without no particular limitation. For example, it is possible to improve the efficiency of extraction of light and improve external quantum efficiency by processing the shape of the substrate surface (for example, by forming a minute concave-convex pattern), by controlling the refractive indices of the substrate, ITO layer and organic layer, and by controlling the thicknesses of the substrate, ITO layer and organic layer.

Light extraction from the organic electroluminescence element of the present invention may be a top emission system or a bottom emission system.

The organic electroluminescence element may have a resonator structure. For example, the organic electroluminescence element has a multilayer film mirror including a plurality of laminated films different in refractive index, a transparent or translucent electrode, a light emitting layer, and a metal electrode by superposition on a transparent substrate. The light generated from the light emitting layer repeats reflection and resonates between the multilayer film mirror and the metal electrode as reflectors.

As another preferred embodiment, a transparent or translucent electrode and a metal electrode respectively function as reflectors on a transparent substrate, and light generated from the light emitting layer repeats reflection and resonates between them.

To form a resonance structure, effective refractive indices of two reflectors, optical path determined by the refractive index and thickness of each layer between the reflectors are adjusted to be optimal values to obtain a desired resonance wavelength. The expression of the case of the first embodiment is disclosed in Japanese Patent Application Laid-Open (JP-A) No. 09-180883. The expression of the case of the second embodiment is disclosed in Japanese Patent Application Laid-Open (JP-A) No. 2004-127795.

### - Application -

Application of the organic electroluminescence element of the present invention is not particularly limited and may be suitably selected in accordance with the intended use. For example, the organic electroluminescence element of the present invention can be suitably utilized in display devices, displays, back light, electrophotography, illumination light sources, recording light sources, exposure light sources, reading light sources, signs, advertizing sign boards, interiors, optical communication, etc.

As a method of making the organic EL display device full colors, for example, as described in Monthly Display, pp. 33-37 (September, 2000), a three-color light-emitting method of arranging organic EL elements emitting lights corresponding to three primary colors (blue (B), green (G) and red (R)) of colors on a substrate, a white color method of separating white color emission by an organic EL element for white color emission to three colors through a color filter, and a color-converting method of converting blue color emission by an organic EL element for blue color emission to red (R) and green (G) through a fluorescent dye layer are known. Further, by using in combination of a plurality of organic EL elements different in luminescent colors capable of obtaining by the above method, plane light sources of desired luminescent colors can be obtained. For example, a white emission light source of combining luminescence devices of blue and yellow luminescence devices, and a white emission light source of combining luminescence devices of blue, green and red are exemplified.

### Examples

Hereinafter, the present invention will be described with reference to Examples, which, however, shall not be construed as limiting the scope of the present invention.

### (Comparative Example 1)

### - Production of Organic Electroluminescence Element -

A 0.5-mm thickness and 2.5-cm square glass substrate was placed in a washing container, and subjected to ultrasonic wave washing with 2-propanol, followed by UV-ozone treatment for 30 minutes. Then, the following individual layers were vapor deposited on the glass substrate by a vacuum vapor deposition method. Note that the deposition rate employed in the following Examples and Comparative Examples is 0.2 nm/sec, unless otherwise specified. The deposition rate was measured by a quartz oscillator. In addition, the thickness of each of the following layers was measured by a quartz oscillator.

Firstly, on the glass substrate, ITO (Indium Tin Oxide) was deposited as an anode by sputtering in a thickness of 100 nm.

Next, on the anode (ITO), 2-TNATA(4,4',4"-Tris(N-(2-naphtyl)-N-phenyl-amino)-triphenylamine)was deposited as a hole injection layer in a thickness of 140 nm.

Next, on the hole injection layer, α-NPD(Bis[N-(1-naphthyl)-N-pheny]benzidine) was deposited as a hole transporting layer in a thickness of 7 nm.

Next, on the hole transporting layer, Amine Compound 1 represented by the following structural formula was deposited as a second hole transporting layer in a thickness of 3 nm.

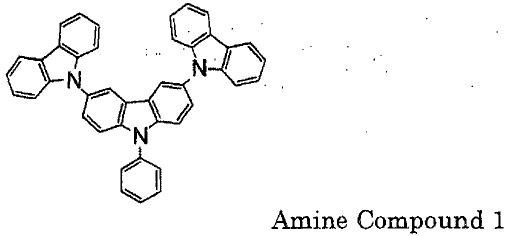

Next, on the second hole transporting layer, a light emitting layer in which H-4[mCP;(N,N'-dicarbazolyl-3,5-benzene)] represented by the following structural formula and serving as a hole transporting host material was doped with 6.0% by mass of Firpic[iridium(III)bis[4,6-di-fluorophenyl]-pyridinato-)picolinate] serving as a hole-transporting phosphorous light emitting material, was deposited in a thickness of 30 nm.

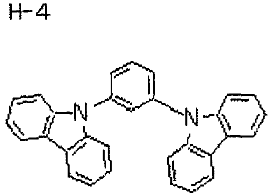

Next, on the light emitting layer, Nitrogen-Containing Heterocyclic Derivative 1 serving as a high electron transporting material represented by the following structural formula and contained in General Formula (1) was deposited as an electron transporting layer in a thickness of 40 nm.

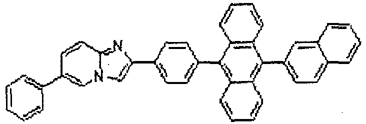

### Nitrogen-contaiing heterocyclic derivative 1

Next, on the electron transporting layer, LiF was deposited as an electron injecting layer so as to have a thickness of 1 nm.

Next, on the electron injecting layer, a mask patterned as a cathode (a mask allowing a light emission area to be 2 mm x 2 mm) was disposed, and then a metal aluminum was deposited in a thickness of 100 nm.

A laminated produced by the above process was placed in a groove box purged with argon gas and sealed using a stainless-steel sealing can and a ultraviolet-curable adhesive (XNR5516HV, produced by Nagase Chemtex Corp.), and thereby an organic electroluminescence element of Comparative Example 1 was produced.

### (Comparative Example 2)

### - Production of Organic Electroluminescence Element -

An organic electroluminescence element was produced in the same manner as in Comparative Example 1, except that BAlq[Bis-(2-methyl-8-quinolinolato)-4-(phenyl-phenolate)-aluminum-(III) serving as a low electron transporting material was used as an electron transporting layer.

### (Comparative Example 3)

### - Production of Organic Electroluminescence Element -

An organic electroluminescence element was produced in the same manner as in Comparative Example 2, except that D-1 serving as an electron-transporting phosphorous light emitting material represented by the following structural formula contained in General Formula (15a-3) was used as a light emitting material.

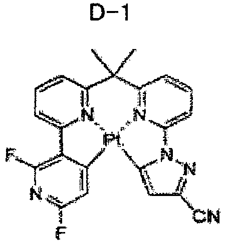

### (Example 1)

### - Production of Organic Electroluminescence Element -

An organic electroluminescence element was produced in the same manner as in Comparative Example 1, except that D-1 represented by the above-described structural formula was used as a light emitting material, instead of Firpic.

### (Example 2)

### - Production of Organic Electroluminescence Element -

An organic electroluminescence element was produced in the same manner as in Example 1, except that Nitrogen-containing heterocyclic derivative 2 represented by the following structural formula was used as an electron transporting layer.

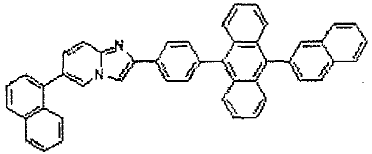

### Nitrogen-containing heterocyclic derivative 2

### (Example 3)

### - Production of Organic Electroluminescence Element -

An organic electroluminescence element was produced in the same manner as in Example 1, except that Nitrogen-containing heterocyclic derivative 3 represented by the following structural formula was used as an electron transporting layer.

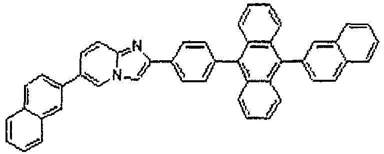

### Nitrogen-containing heterocyclic derivative 3

### (Example 4)

### - Production of Organic Electroluminescence Element -

An organic electroluminescence element was produced in the same manner as in Example 1, except that Nitrogen-containing heterocyclic derivative 4 represented by the following structural formula was used as an electron transporting layer.

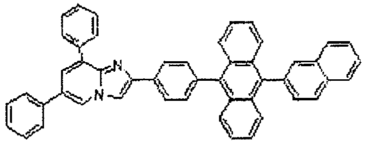

### Nitrogen-containing heterocyclic derivative 4

### (Example 5)

### - Production of Organic Electroluminescence Element -

An organic electroluminescence element was produced in the same manner as in Example 1, except that D-2 represented by the following structural formula was used as a light emitting material.

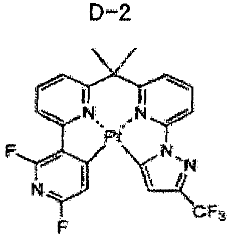

### (Example 6)

### - Production of Organic Electroluminescence Element -

An organic electroluminescence element was produced in the same manner as in Example 5, except that H-24 represented by the following structural formula 2 was used as a host material and Nitrogen-containing heterocyclic derivative 2 represented by the above-described structural formula was used as an electron transporting layer.

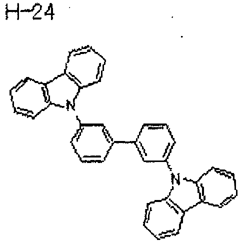

### (Example 7)

### - Production of Organic Electroluminescence Element -

An organic electroluminescence element was produced in the same manner as in Example 5, except that H-27 represented by the following structural formula was used as a host material and Nitrogen-containing heterocyclic derivative 3 represented by the above-described structural formula was used as an electron transporting layer.

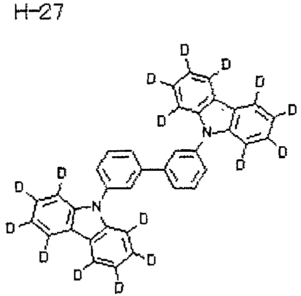

### (Example 8)

### - Production of Organic Electroluminescence Element -

An organic electroluminescence element was produced in the same manner as in Example 1, except that H-17 represented by the following structural formula was used as a host material, D-3 represented by the following structural formula was used as a light emitting material, and Nitrogen-containing heterocyclic derivative 4 represented by the above-described structural formula was used as an electron transporting layer.

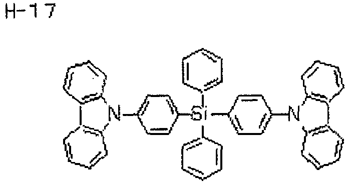

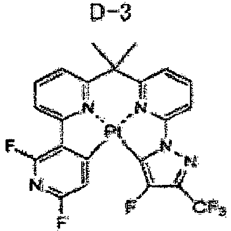

### (Example 9)

### - Production of Organic Electroluminescence Element -

An organic electroluminescence element was produced in the same manner as in Example 1, except that D-4 represented by the following structural formula was used as a light emitting material.

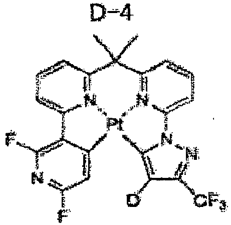

### (Example 10)

### - Production of Organic Electroluminescence Element -

An organic electroluminescence element was produced in the same manner as in Example 9, except that H-24 represented by the following structural formula was used as a host material, and Nitrogen-containing heterocyclic derivative 2 represented by the above-described structural formula was used as an electron transporting layer.

### (Example 11)

### - Production of Organic Electroluminescence Element -

An organic electroluminescence element was produced in the same manner as in Example 1, except that D-5 represented by the following structural formula was used as a light emitting material, and Nitrogen-containing heterocyclic derivative 3 represented by the above-described structural formula was used as an electron transporting layer.

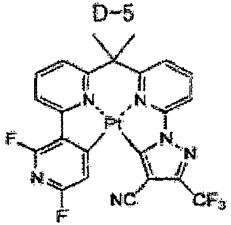

### (Example 12)

### - Production of Organic Electroluminescence Element -

An organic electroluminescence element was produced in the same manner as in Example 1, except that D-9 represented by the following structural formula was used as a light emitting material, and Nitrogen-containing heterocyclic derivative 4 represented by the above-described structural formula was used as an electron transporting layer.

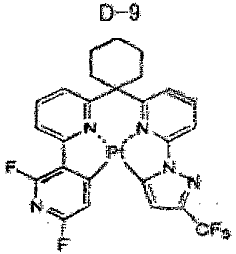

### (Example 13)

### - Production of Organic Electroluminescence Element -

An organic electroluminescence element was produced in the same manner as in Example 12, except that Nitrogen-containing heterocyclic derivative 1 represented by the above-described structural formula was used as an electron transporting layer.

### (Example 14)

### - Production of Organic Electroluminescence Element -

An organic electroluminescence element was produced in the same manner as in Example 2, except that D-10 represented by the following structural formula was used as a light emitting material

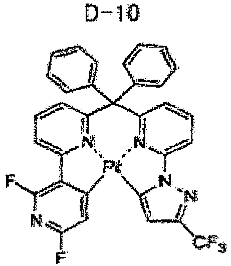

### (Example 15)

### - Production of Organic Electroluminescence Element -

An organic electroluminescence element was produced in the same manner as in Example 14, except that Nitrogen-containing heterocyclic derivative 3 represented by the above-described structural formula was used as an electron transporting layer.

### (Example 16)

### - Production of Organic Electroluminescence Element -

An organic electroluminescence element was produced in the same manner as in Example 4, except that D-14 represented by the following structural formula was used as a light emitting material

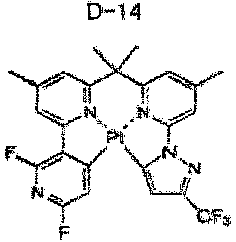

### (Example 17)

### - Production of Organic Electroluminescence Element -

An organic electroluminescence element was produced in the same manner as in Example 1, except that D-15 represented by the following structural formula was used as a light emitting material

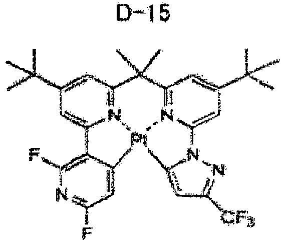

### (Example 18)

### - Production of Organic Electroluminescence Element -

An organic electroluminescence element was produced in the same manner as in Example 2, except that D-23 represented by the following structural formula was used as a light emitting material

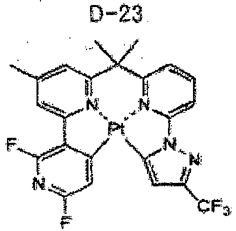

### (Example 19)

### - Production of Organic Electroluminescence Element -

An organic electroluminescence element was produced in the same manner as in Example 3, except that D-24 represented by the following structural formula was used as a light emitting material

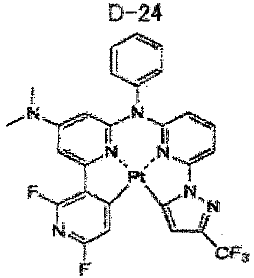

### (Example 20)

### - Production of Organic Electroluminescence Element -

An organic electroluminescence element was produced in the same manner as in Example 19, except that Nitrogen-containing heterocyclic derivative 4 represented by the above-described structural formula was used as an electron transporting layer.

Next, as for the organic electroluminescence elements produced in Examples 1 to 20 and Comparative Examples 1 to 3, the driving voltage and external quantum efficiency were measured. Table 1 shows the measurement results.

### < Measurement of Driving Voltage >

SOURCE MEASURE UNIT 2400 manufactured by Toyo Technica Co. was used and a direct-current voltage was applied to each of the organic electroluminescence elements to allow it to emit light. The voltage when the current was 10 mA/cm² was measured as its driving voltage.

### < Measurement of External Quantum Efficiency >

SOURCE MEASURE UNIT 2400 manufactured by Toyo Technica Co. was used and a direct-current voltage was applied to each of the organic electroluminescence elements to allow it to emit light. A light emission spectrum and luminance were measured using a spectrum analyzer SR-3 manufactured by TOPCON Corp., and based on these measured values, the external quantum efficiency at which the current was 10 mA/cm² was calculated by the luminance conversion method.

**Table 1**

| | Host material | Light emitting material | Electron transporting material | Driving voltage (V) | External quantum efficiency (%) |
|---|---|---|---|---|---|
| | | | | 10 mA/cm² | 10 mA/cm² |
| Comp. Ex. 1 | H-4 | Firpic | Derivative 1 | 4.8 | 5 |
| Comp. Ex. 2 | H-4 | Firpic | BAlq | 6.0 | 8 |
| Comp. Ex. 3 | H-4 | D-1 | BAlq | 5.8 | 12 |
| Ex. 1 | H-4 | D-1 | Derivative 1 | 4.6 | 13 |
| Ex. 2 | H-4 | D-1 | Derivative 2 | 4.8 | 12 |
| Ex. 3 | H-4 | D-1 | Derivative 3 | 4.6 | 12 |
| Ex. 4 | H-4 | D-1 | Derivative 4 | 4.9 | 13 |
| Ex. 5 | H-4 | D-2 | Derivative 1 | 4.8 | 14 |
| Ex. 6 | H-24 | D-2 | Derivative 2 | 4.8 | 14 |
| Ex. 7 | H-27 | D-2 | Derivative 3 | 4.6 | 15 |
| Ex. 8 | H-17 | D-3 | Derivative 4 | 4.7 | 12 |
| Ex. 9 | H-4 | D-4 | Derivative 1 | 4.5 | 11 |
| Ex. 10 | H-24 | D-4 | Derivative 2 | 4.6 | 11 |
| Ex. 11 | H-4 | D-5 | Derivative 3 | 4.6 | 13 |
| Ex. 12 | H-4 | D-9 | Derivative 4 | 4.7 | 10 |
| Ex. 13 | H-4 | D-9 | Derivative 1 | 4.6 | 10 |
| Ex. 14 | H-4 | D-10 | Derivative 2 | 4.7 | 13 |
| Ex. 15 | H-4 | D-10 | Derivative 3 | 4.8 | 13 |
| Ex. 16 | H-4 | D-14 | Derivative 4 | 4.7 | 9 |
| Ex. 17 | H-4 | D-15 | Derivative 1 | 4.7 | 12 |
| Ex. 18 | H-4 | D-23 | Derivative 2 | 4.5 | 11 |
| Ex. 19 | H-4 | D-24 | Derivative 3 | 4.6 | 12 |
| Ex. 20 | H-4 | D-24 | Derivative 4 | 4.8 | 12 |

From the results shown in Table 1, it can be seen that when Comparative Example 1 was compared to Comparative Example 2, in the case of using Firpic serving as a hole-transporting phosphorescence emission material was used and the material of an electron transporting layer was changed from BAlq serving as a low-electron transporting material to Nitrogen-containing heterocyclic derivative 1 serving as a high-electron transporting material, the driving voltage was surely reduced, but a reduction in external quantum efficiency was caused, and the effect of high-quantum efficiency and low-voltage brought by the phosphorous light emitting material could not be simultaneously achieved.

However, when Comparative Example 3 using the platinum complex containing a tetradentate ligand (D-1) serving as an electron transporting phosphorous light emitting material to Example 1, a significant lower voltage effect could be seen by changing the electron transporting layer material from BAlq to Nitrogen-containing heterocyclic derivative 1, and further high external quantum efficiency could be maintained. In addition, in Examples 2 to 4, similar effects were recognized in three types of Nitrogen-containing heterocyclic derivatives, and in Examples 5 to 20, similar effects were recognized in the electron-transporting phosphorous light emitting material satisfying General Formula (2).

### (Comparative Example 4)

### - Production of Organic Electroluminescence Element -

An organic electroluminescence element was produced in the same manner as in Comparative Example 1, except that 2-TNATA used as the hole injecting layer was changed to DNTPD(N,N'-bis-[4-(di-m-tolylamino)phenyl]-N,N'-diphenylbiphenyl-4,4'-diamine).

### (Example 21)

### - Production of Organic Electroluminescence Element -

An organic electroluminescence element was produced in the same manner as in Comparative Example 4, except that Firpic used as a light emitting material was changed to D-1 represented by the following structural formula.

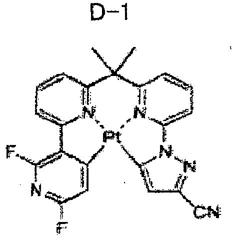

### (Example 22)

### - Production of Organic Electroluminescence Element -

An organic electroluminescence element was produced in the same manner as in Comparative Example 21, except that Nitrogen-containing heterocyclic derivative 2 represented by the following structural formula was used as an electron transporting layer.

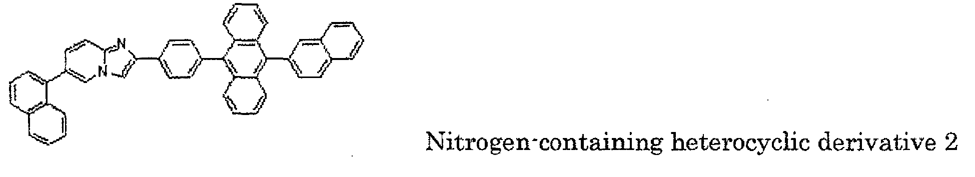

### (Example 23)

### - Production of Organic Electroluminescence Element -

An organic electroluminescence element was produced in the same manner as in Comparative Example 21, except that Nitrogen-containing heterocyclic derivative 3 represented by the following structural formula was used as an electron transporting layer.

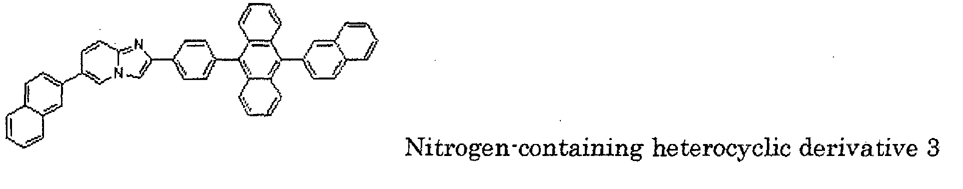

As for the resulting organic electroluminescence elements of Comparative Example 4 and Examples 21 to 23, the driving voltage and external quantum efficiency were measured according to the same procedures. Table 2 shows the measurement results.

**Table 2**

| | Host material | Light emitting material | Electron transporting material | Driving voltage (V) | External quantum efficiency (%) |
|---|---|---|---|---|---|
| | | | | 10 mA/cm² | 10 mA/cm² |
| Comp. Ex. 4 | H-4 | Firpic | Derivative 1 | 4.8 | 5 |
| Ex. 21 | H-4 | D-1 | Derivative 1 | 4.6 | 13 |
| Ex. 22 | H-4 | D-1 | Derivative 2 | 4.8 | 12 |
| Ex. 23 | H-4 | D-1 | Derivative 3 | 4.6 | 12 |

### Industrial Applicability

Since the organic electroluminescence element of the present invention enables reducing voltage in drying voltage and maintaining high light emission efficiency, it can be suitably utilized, for example, in display devices, displays, back light, electrophotography, illumination light sources, recording light sources, exposure light sources, reading light sources, signs, advertizing sign boards, interiors, optical communication, etc.

## Claims

1. An organic electroluminescence element comprising:
at least one organic layer including a light emitting layer, between an anode and a cathode,
wherein at least one layer of the at least one organic layer contains at least one selected from nitrogen-containing heterocyclic derivatives represented by General Formula (1) below, and at least one layer of the at least one organic layer contains an electron-transporting phosphorous light emitting material represented by General Formula (15a-3) below, 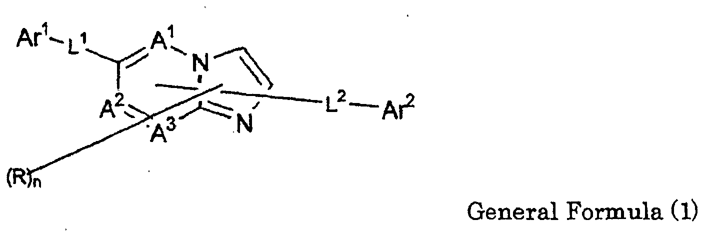 where A¹ to A³ each independently represent a nitrogen atom or a carbon atom, Ar¹ represents a substituted or unsubstituted aryl group having nucleus carbon atoms of 6 to 60 or a substituted or unsubstituted heteroaryl group having nucleus carbon atoms of 3 to 60, Ar² represents a hydrogen atom, a substituted or unsubstituted aryl group having nucleus carbon atoms of 6 to 60, a substituted or unsubstituted heteroaryl group having nucleus carbon atoms of 3 to 60, a substituted or unsubstituted alkyl group having 1 to 20 carbon atoms or a substituted or unsubstituted alkoxy group having 1 to 20 carbon atoms, wherein one of Ar¹ and Ar² is a substituted or unsubstituted condensed ring group having 10 to 60 nucleus carbon atoms or a substituted or unsubstituted monohetero condensed ring group having 3 to 60 nucleus carbon atoms; L¹ and L² each independently represent a single bond, a substituted or unsubstituted arylene group having 6 to 60 nucleus carbon atoms, a substituted or unsubstituted heteroarylene group having 3 to 60 nucleus carbon atoms or a substituted or unsubstituted fluorenylene group; R represents a hydrogen atoms, a substituted or unsubstituted aryl group having 6 to 60 nucleus carbon atoms, a substituted or unsubstituted heteroaryl group having nucleus carbon atoms of 3 to 60, a substituted or unsubstituted alkyl group having 1 to 20 carbon atoms or a substituted or unsubstituted alkoxy group having 1 to 20 carbon atoms; and n is an integer of 0 to 5, when n is 2 or greater, a plurality of Rs may be different from or identical to each other, and adjacent R groups among the plurality of Rs may be bonded to form a carbocyclic aliphatic ring or a carbocyclic aromatic ring, 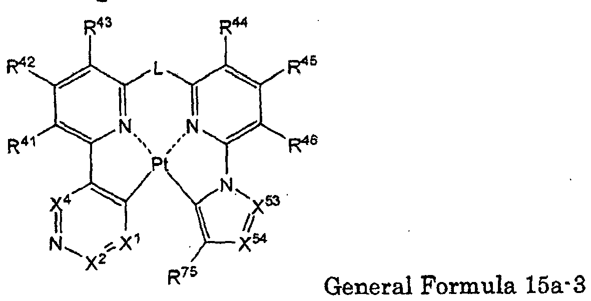 where X¹, X² and X⁴ each independently represent a carbon atom or a nitrogen atom; R⁴¹, R⁴², R⁴³, R⁴⁴, R⁴⁵ and R⁴⁶ each independently represent a hydrogen atom or a substituent; X⁵³ and X⁵⁴ each independently represent a carbon atom or a nitrogen atom, the number of nitrogen atoms contained in a 5-membered ring skeleton containing X⁵³ and X⁵⁴ is 1 or 2; R⁷⁵ represents a hydrogen atom or a substituent; and L represents a single bond or a divalent linking group.

2. The organic electroluminescence element according to claim 1, wherein at least one selected from the nitrogen-containing heterocyclic derivatives represented by General Formula (1) is a nitrogen-containing heterocyclic derivative represented by General Formula (3) below, 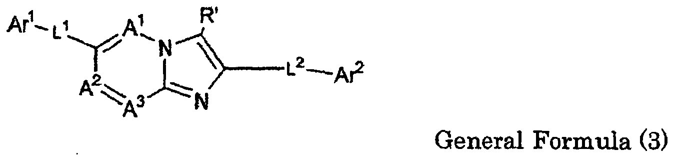 where A¹ to A³ each independently represent a nitrogen atom or a carbon atom, Ar¹ represents a substituted or unsubstituted aryl group having nucleus carbon atoms of 6 to 60 or a substituted or unsubstituted heteroaryl group having nucleus carbon atoms of 3 to 60, Ar² represents a hydrogen atom, a substituted or unsubstituted aryl group having nucleus carbon atoms of 6 to 60, a substituted or unsubstituted heteroaryl group having nucleus carbon atoms of 3 to 60, a substituted or unsubstituted alkyl group having 1 to 20 carbon atoms or a substituted or unsubstituted alkoxy group having 1 to 20 carbon atoms, wherein one of Ar¹ and Ar² is a substituted or unsubstituted condensed ring group having nucleus carbon atoms of 10 to 60 or a substituted or unsubstituted monohetero condensed ring group having nucleus carbon atoms of 3 to 60; L¹ and L² each independently represent a single bond, a substituted or unsubstituted arylene group having 6 to 60 nucleus carbon atoms, a substituted or unsubstituted heteroarylene group having 3 to 60 nucleus carbon atoms or a substituted or unsubstituted fluorenylene group; and R' represents a hydrogen atom, a substituted or unsubstituted aryl group having 6 to 60 nucleus carbon atoms, a substituted or unsubstituted heteroaryl group having 3 to 60 nucleus carbon atoms, a substituted or unsubstituted alkyl group having 1 to 20 carbon atoms or a substituted or unsubstituted alkoxy group having 1 to 20 carbon atoms.

3. The organic electroluminescence element according to claim 2, wherein the nitrogen-containing heterocyclic derivative represented by General Formula (3) is a nitrogen-containing heterocyclic derivative represented by General Formula (4). 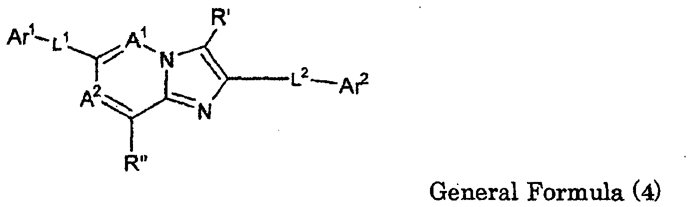 where A¹ and A² each independently represent a nitrogen atom or a carbon atom, Ar¹ represents a substituted or unsubstituted aryl group having nucleus carbon atoms of 6 to 60 or a substituted or unsubstituted heteroaryl group having nucleus carbon atoms of 3 to 60, Ar² represents a hydrogen atom, a substituted or unsubstituted aryl group having nucleus carbon atoms of 6 to 60, a substituted or unsubstituted heteroaryl group having nucleus carbon atoms of 3 to 60, a substituted or unsubstituted alkyl group having 1 to 20 carbon atoms or a substituted or unsubstituted alkoxy group having 1 to 20 carbon atoms, wherein one of Ar¹ and Ar² is a substituted or unsubstituted condensed ring group having 10 to 60 nucleus carbon atoms or a substituted or unsubstituted monohetero condensed ring group having 3 to 60 nucleus carbon atoms; L¹ and L² each independently represent a single bond, a substituted or unsubstituted arylene group having 6 to 60 nucleus carbon atoms, a substituted or unsubstituted heteroarylene group having 3 to 60 nucleus carbon atoms or a substituted or unsubstituted fluorenylene group; and R' and R" each independently represent a hydrogen atom, a substituted or unsubstituted aryl group having 6 to 60 nucleus carbon atoms, a substituted or unsubstituted heteroaryl group having 3 to 60 nucleus carbon atoms, a substituted or unsubstituted alkyl group having 1 to 20 carbon atoms or a substituted or unsubstituted alkoxy group having 1 to 20 carbon atoms, R' and R" may be different from or identical to each other.

4. The organic electroluminescence element according to any one of claims 1 to 3, wherein in the nitrogen-containing heterocyclic derivative represented by any one of General Formulae (1), (3) and (4), at least one of L¹ and L² is selected from groups each independently represented by Structural Formulae below:

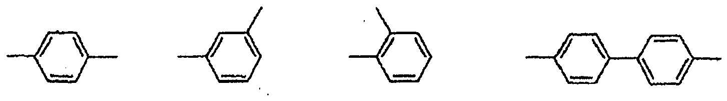

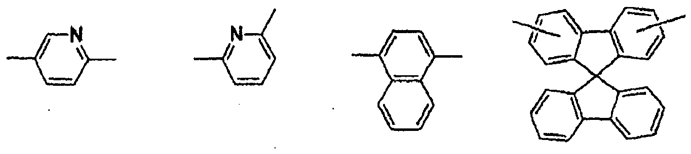

5. The organic electroluminescence element according to any one of claims 1 to 4, wherein in the nitrogen-containing heterocyclic derivative represented by any one of General Formulae (1), (3) and (4), Ar¹ is a group represented by any one of General Formulae (5) to (14) below: 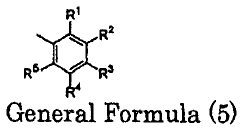 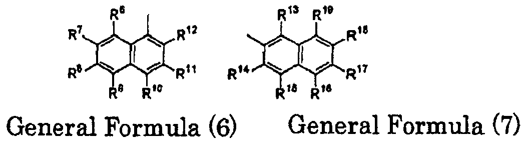 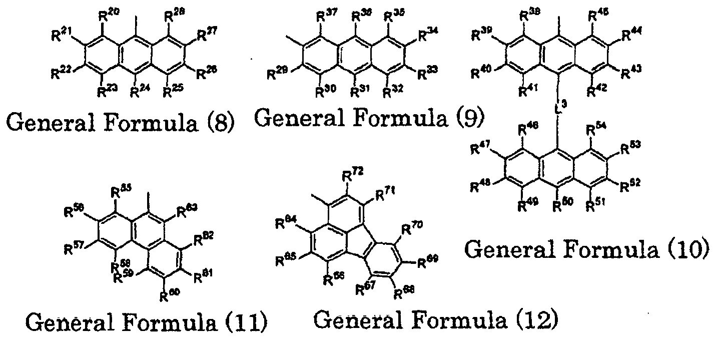 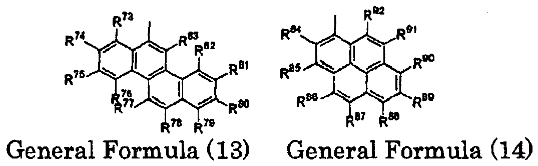 where R¹ to R⁹² each independently represent a hydrogen atom, a halogen atom, a substituted or unsubstituted alkyl group having 1 to 20 carbon atoms, a substituted or unsubstituted alkoxy group having 1 to 20 carbon atoms, a substituted or unsubstituted aryloxy group having 6 to 40 nucleus carbon atoms, a substituted or unsubstituted diarylamino group having 12 to 80 nucleus carbon atoms, a substituted or unsubstituted aryl group having 6 to 40 nucleus carbon atoms, a substituted or unsubstituted heteroaryl group having 3 to 40 nucleus carbon atoms, or a substituted or unsubstituted diarylaminoaryl group having 18 to 120 nucleus carbon atoms; and L³ represents a single bond or a substituent represented by any one of Structural Formulae below:

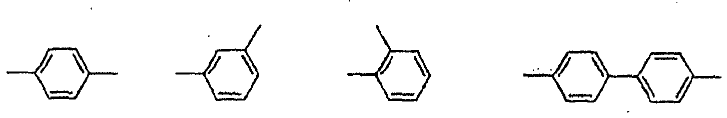

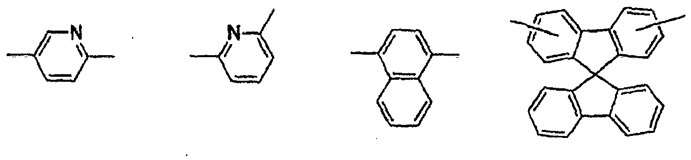

6. The organic electroluminescence element according to any one of claims 1 to 5, wherein the light emitting layer contains at least one of a metal complex compound containing a polydentate ligand having a partial structure represented by General Formula (2) and the platinum complex compound containing the tetradentate ligand represented by General Formula 15a-3. 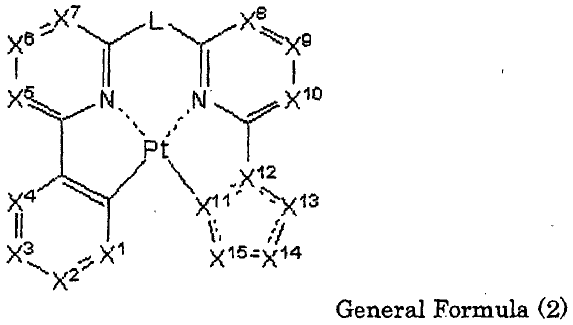 where X¹, X², X³ and X⁴ each independently represent a carbon atom or a nitrogen atom, and one or more selected from X¹, X², X³ and X⁴ represent(s) a nitrogen atom; X⁵, X⁶, X⁷, X⁸, X⁹ and X¹⁰ each independently represent a carbon atom or a nitrogen atom; X¹¹ and X¹² each independently represent a carbon atom or a nitrogen atom; X¹³, X¹⁴ and X¹⁵ each independently represent a carbon atom, a nitrogen atom, an oxygen atom or a sulfur atom, the number of nitrogen atoms contained in a five-membered ring skeleton represented by any one of X¹¹, X¹², X¹³, X¹⁴ and X¹⁵ is 2 or smaller; and L represents a single bond or a divalent linking group.

7. The organic electroluminescence element according to any one of claims 1 to 6, wherein the light emitting layer contains at least one of a metal complex compound containing a polydentate ligand having a partial structure represented by General Formula (2), a platinum complex compound containing a tetradentate ligand represented by General Formula 15a-3and at last one host material.

8. The organic electroluminescence element according to claim 7, wherein the at least one host material is hole-transportable.

9. The organic electroluminescence element according to any one of claims 1 to 8, wherein the nitrogen-containing heterocyclic derivative functions as at least one of an electron injection material and an electron transporting material.

10. The organic electroluminescence element according to any one of claims 1 to 9, wherein the layer containing the nitrogen-containing heterocyclic derivative contains a reducing dopant.

11. The organic electroluminescence element according to claim 10, wherein the reducing dopant is at least one selected from alkali metals, alkaline earth metals, rare earth metals, alkali metal oxides, alkali metal halides, alkali earth metal oxides, alkali earth metal halides, rare earth metal oxides, rare earth metal halides, alkali metal organic complexes, alkali earth metal organic complexes, and rare earth metal organic complexes.

## Patentansprüche

1. Organisches Elektrolumineszenzelement, umfassend:
mindestens eine organische Schicht, die eine lichtemittierende Schicht einschließt, zwischen einer Anode und einer Kathode,
worin mindestens eine Schicht der mindestens einen organischen Schicht mindestens eines aus Stickstoff enthaltenden heterocyclischen Derivaten der allgemeinen Formel (1) unten enthält und mindestens eine Schicht der mindestens einen organischen Schicht ein Elektronentransportierendes lichtemittierendes Leuchtstoffmaterial der allgemeinen Formel (15a-3) unten enthält 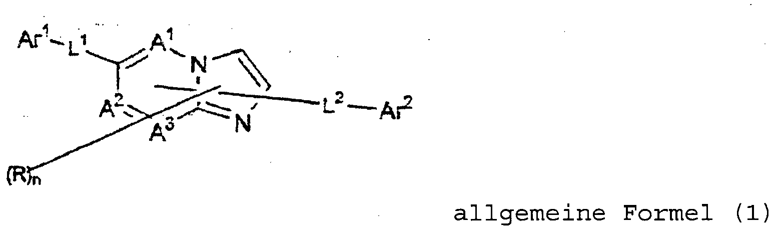 worin A¹ bis A³ jeweils unabhängig voneinander ein Stickstoffatom oder ein Kohlenstoffatom darstellen, Ar¹ eine substituierte oder unsubstituierte Arylgruppe mit 6 bis 60 Kern-Kohlenstoffatomen oder eine substituierte oder unsubstituierte Heteroarylgruppe mit 3 bis 60 Kern-Kohlenstoffatomen darstellt, Ar² ein Wasserstoffatom, eine substituierte oder unsubstituierte Arylgruppe mit 6 bis 60 Kern-Kohlenstoffatomen, eine substituierte oder unsubstituierte Heteroarylgruppe mit 3 bis 60 Kern-Kohlenstoffatomen, eine substituierte oder unsubstituierte Alkylgruppe mit 1 bis 20 Kohlenstoffatomen oder eine substituierte oder unsubstituierte Alkoxygruppe mit 1 bis 20 Kohlenstoffatomen darstellt, worin eines aus Ar¹ und Ar² eine substituierte oder unsubstituierte kondensierte Ringgruppe mit 10 bis 60 Kern-Kohlenstoffatomen oder eine substituierte oder unsubstituierte Monoheterokondensierte Ringgruppe mit 3 bis 60 KernKohlenstoffatomen ist; L¹ und L² jeweils unabhängig voneinander eine Einfachbindung, eine substituierte oder unsubstituierte Arylengruppe mit 6 bis 60 KernKohlenstoffatomen, eine substituierte oder unsubstituierte Heteroarylengruppe mit 3 bis 60 KernKohlenstoffatomen oder eine substituierte oder unsubstituierte Fluorenylengruppe darstellt; R ein Wasserstoffatom, eine substituierte oder unsubstituierte Arylgruppe mit 6 bis 60 Kern-Kohlenstoffatomen, eine substituierte oder unsubstituierte Heteroarylgruppe mit 3 bis 60 Kern-Kohlenstoffatomen, eine substituierte oder unsubstituierte Alkylgruppe mit 1 bis 20 Kohlenstoffatomen oder eine substituierte oder unsubstituierte Alkoxygruppe mit 1 bis 20 Kohlenstoffatomen darstellt; und n eine ganze Zahl von 0 bis 5 ist, wobei, wenn n 2 oder größer ist, eine Mehrzahl von R gleich oder unterschiedlich voneinander sein können, und benachbarte R-Gruppen in der Mehrzahl der R miteinander verbunden sein können, um einen carbocyclischen aliphatischen Ring oder eine carbocyclischen aromatischen Ring zu bilden, 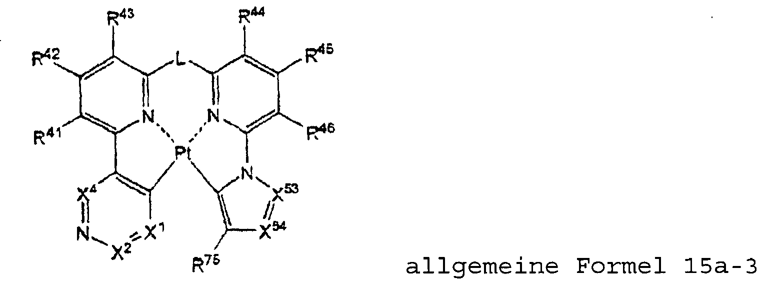 worin X¹, X² und X⁴ jeweils unabhängig ein Kohlenstoffatom oder eine Stickstoffatom darstellen; R⁴¹, R⁴², R⁴³, R⁴⁴, R⁴⁵ und R⁴⁶ jeweils unabhängig ein Wasserstoffatom oder einen Substituenten darstellen; X⁵³ und X⁵⁴ jeweils unabhängig ein Kohlenstoffatom oder ein Stickstoffatom darstellen, wobei die Anzahl der Stickstoffatome, die im 5-gliedrigen Ringgerüst, das X⁵³ und X⁵⁴ enthält, enthalten sind, 1 oder 2 ist; R⁷⁵ ein Wasserstoffatom oder einen Substituenten darstellt; und L eine Einfachbindung oder eine zweiwertige verknüpfende Gruppe darstellt.

2. Organisches Elektrolumineszenzelement gemäß Anspruch 1, worin mindestens eines ausgewählt aus den Stickstoff enthaltenden heterocyclischen Derivaten der allgemeinen Formel (1) ein Stickstoff enthaltendes heterocyclisches Derivat der allgemeinen Formel (3) unten ist, 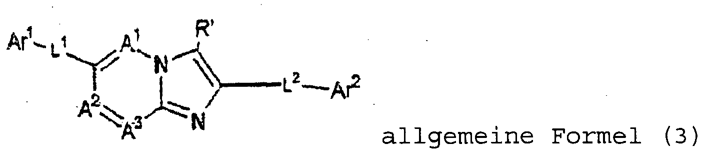 worin A¹ bis A³ jeweils unabhängig voneinander ein Stickstoffatom oder ein Kohlenstoffatom darstellen, Ar¹ eine substituierte oder unsubstituierte Arylgruppe mit 6 bis 60 Kern-Kohlenstoffatomen oder eine substituierte oder unsubstituierte Heteroarylgruppe mit 3 bis 60 Kern-Kohlenstoffatomen darstellt, Ar² ein Wasserstoffatom, eine substituierte oder unsubstituierte Arylgruppe mit 6 bis 60 Kern-Kohlenstoffatomen, eine substituierte oder unsubstituierte Heteroarylgruppe mit 3 bis 60 Kern-Kohlenstoffatomen, eine substituierte oder unsubstituierte Alkylgruppe mit 1 bis 20 Kohlenstoffatomen oder eine substituierte oder unsubstituierte Alkoxygruppe mit 1 bis 20 Kohlenstoffatomen darstellt, worin eines aus Ar¹ und Ar² eine substituierte oder unsubstituierte kondensierte Ringgruppe mit 10 bis 60 Kern-Kohlenstoffatomen oder eine substituierte oder unsubstituierte Monoheterokondensierte Ringgruppe mit 3 bis 60 Kern-Kohlenstoffatomen ist; L¹ und L² jeweils unabhängig voneinander eine Einfachbindung, eine substituierte oder unsubstituierte Arylengruppe mit 6 bis 60 Kern-Kohlenstoffatomen, eine substituierte oder unsubstituierte Heteroarylengruppe mit 3 bis 60 Kern-Kohlenstoffatomen oder eine substituierte oder unsubstituierte Fluorenylengruppe darstellt; und R' ein Wasserstoffatom, eine substituierte oder unsubstituierte Arylgruppe mit 6 bis 60 Kern-Kohlenstoffatomen, eine substituierte oder unsubstituierte Heteroarylgruppe mit 3 bis 60 Kern-Kohlenstoffatomen, eine substituierte oder unsubstituierte Alkylgruppe mit 1 bis 20 Kohlenstoffatomen oder eine substituierte oder unsubstituierte Alkoxygruppe mit 1 bis 20 Kohlenstoffatomen darstellt.

3. Organisches Elektrolumineszenzelement gemäß Anspruch 2, worin das Stickstoff enthaltende heterocyclische Derivat der allgemeinen Formel (3) ein Stickstoff enthaltendes heterocyclisches Derivat der allgemeinen Formel (4) ist 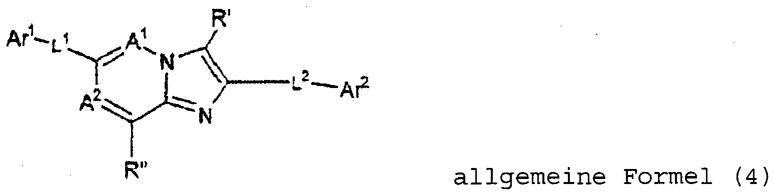 worin A¹ und A² jeweils unabhängig voneinander ein Stickstoffatom oder ein Kohlenstoffatom darstellen, Ar¹ eine substituierte oder unsubstituierte Arylgruppe mit 6 bis 60 Kern-Kohlenstoffatomen oder eine substituierte oder unsubstituierte Heteroarylgruppe mit 3 bis 60 Kern-Kohlenstoffatomen darstellt, Ar² ein Wasserstoffatom, eine substituierte oder unsubstituierte Arylgruppe mit 6 bis 60 Kern-Kohlenstoffatomen, eine substituierte oder unsubstituierte Heteroarylgruppe mit 3 bis 60 Kern-Kohlenstoffatomen, eine substituierte oder unsubstituierte Alkylgruppe mit 1 bis 20 Kohlenstoffatomen oder eine substituierte oder unsubstituierte Alkoxygruppe mit 1 bis 20 Kohlenstoffatomen darstellt, worin eines aus Ar¹ und Ar² eine substituierte oder unsubstituierte kondensierte Ringgruppe mit 10 bis 60 Kern-Kohlenstoffatomen oder eine substituierte oder unsubstituierte Monoheterokondensierte Ringgruppe mit 3 bis 60 Kern-Kohlenstoffatomen ist; L¹ und L² jeweils unabhängig voneinander eine Einfachbindung, eine substituierte oder unsubstituierte Arylengruppe mit 6 bis 60 Kern-Kohlenstoffatomen, eine substituierte oder unsubstituierte Heteroarylengruppe mit 3 bis 60 Kern-Kohlenstoffatomen oder eine substituierte oder unsubstituierte Fluorenylengruppe darstellt; und R' und R" jeweils unabhängig voneinander ein Wasserstoffatom, eine substituierte oder unsubstituierte Arylgruppe mit 6 bis 60 Kern-Kohlenstoffatomen, eine substituierte oder unsubstituierte Heteroarylgruppe mit 3 bis 60 Kern-Kohlenstoffatomen, eine substituierte oder unsubstituierte Alkylgruppe mit 1 bis 20 Kohlenstoffatomen oder eine substituierte oder unsubstituierte Alkoxygruppe mit 1 bis 20 Kohlenstoffatomen darstellen, wobei R' und R" unterschiedlich voneinander oder identisch zueinander sein können.

4. Organisches Elektrolumineszenzelement gemäß irgendeinem der Ansprüche 1 bis 3, worin im Stickstoff enthaltenden heterocyclischen Derivat, dargestellt durch gemäß irgendeine der allgemeinen Formeln (1), (3) und (4), mindestens eines aus L¹ und L² aus Gruppen ausgewählt ist, die jeweils unabhängig voneinander durch die folgenden Strukturformeln dargestellt sind:

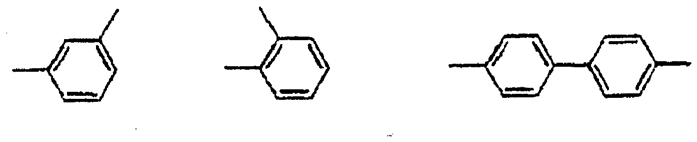

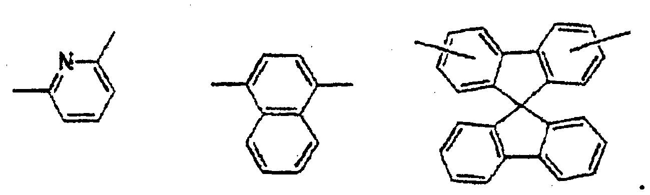

5. Organisches Elektrolumineszenzelement gemäß irgendeinem der Ansprüche 1 bis 4, worin im Stickstoff enthaltenden heterocyclischen Derivat, dargestellt durch irgendeine der allgemeinen Formeln (1), (3) und (4), Ar¹ eine Gruppe ist, die durch irgendeine der folgenden allgemeinen Formeln (5) bis (14) dargestellt ist: 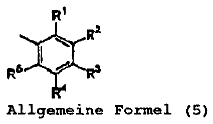 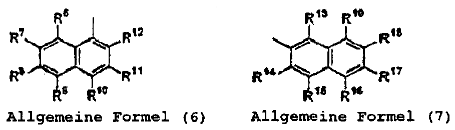 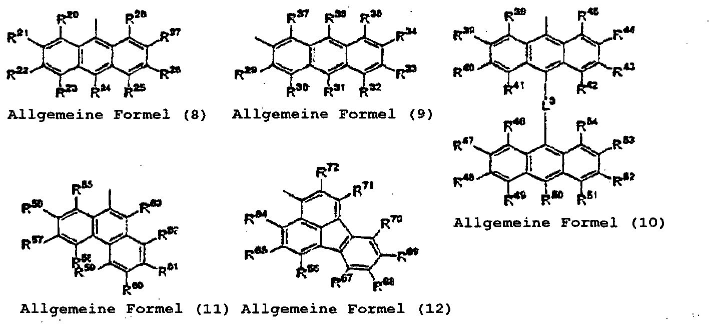 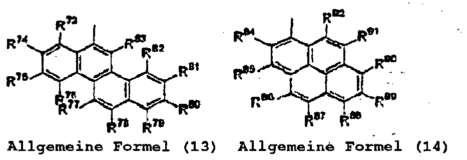 worin R¹ bis R⁹² jeweils unabhängig voneinander ein Wasserstoffatom, ein Halogenatom, eine substituierte oder unsubstituierte Alkylgruppe mit 1 bis 20 Kohlenstoffatomen, eine substituierte oder unsubstituierte Alkoxygruppe mit 1 bis 20 Kohlenstoffatomen, eine substituierte oder unsubstituierte Aryloxygruppe mit 6 bis 40 Kern-Kohlenstoffatomen, eine substituierte oder unsubstituierte Diarylaminogruppe mit 12 bis 80 Kern-Kohlenstoffatomen, eine substituierte oder unsubstituierte Arylgruppe mit 6 bis 40 Kern-Kohlenstoffatomen, eine substituierte oder unsubstituierte Heteroarylgruppe mit 3 bis 40 Kern-Kohlenstoffatomen oder eine substituierte oder unsubstituierte Diarylaminoarylgruppe mit 18 bis 120 Kern-Kohlenstoffatomen darstellt; und L³ eine Einfachbindung oder einen Substituenten darstellt, der durch irgendeine der folgenden Strukturformeln dargestellt ist:

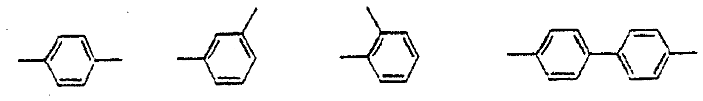

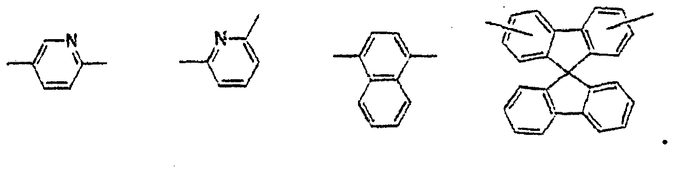

6. Organisches Elektrolumineszenzelement gemäß irgendeinem der Ansprüche 1 bis 5, worin die lichtemittierende Schicht mindestens eines aus einer Metallkomplexverbindung, die einen mehrzähnigen Liganden enthält, der eine Partialstruktur der allgemeinen Formel (2) aufweist, und die Platinkomplexverbindung, die den vierzähnigen Liganden der allgemeinen Formel 15a-3 enthält, enthält: 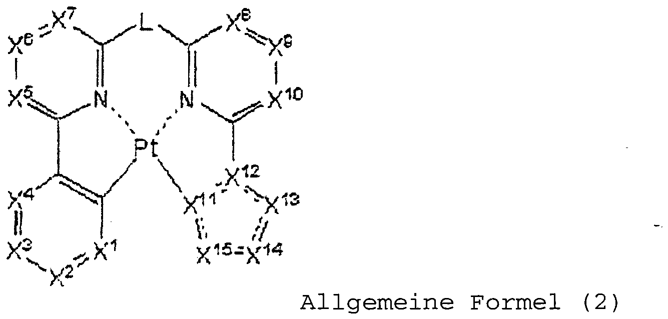 worin X¹, X², X³ und X⁴ jeweils unabhängig voneinander ein Kohlenstoffatom oder ein Stickstoffatom darstellen und ein oder mehrere aus X¹, X², X³ und X⁴ ein Stickstoffatom darstellen; X⁵, X⁶, X⁷, X⁸, X⁹ und X¹⁰ jeweils unabhängig voneinander ein Kohlenstoffatom oder ein Stickstoffatom darstellen; X¹¹ und X¹² jeweils unabhängig voneinander ein Kohlenstoffatom oder ein Stickstoffatom darstellen; X¹³, X¹⁴ und X¹⁵ jeweils unabhängig voneinander ein Kohlenstoffatom, ein Stickstoffatom, ein Sauerstoffatom und ein Schwefelatom darstellen, die Anzahl der im 5-gliedrigen Ringgerüst enthaltenen Stickstoffatome, dargestellt durch irgendeines aus X¹¹, X¹², X¹³, X¹⁴ und X¹⁵ oder kleiner ist; und L eine Einfachbindung oder eine zweiwertige Verknüpfungsgruppe darstellt.

7. Organisches Elektrolumineszenzelement gemäß irgendeinem der Ansprüche 1 bis 6, worin die lichtemittierende Schicht zumindest eines aus einer Metallkomplexverbindung, die einen mehrzähnigen Liganden enthält, der eine Partialstruktur der allgemeinen Formel (2) aufweist, einer Platinkomplexverbindung, die einen vierzähnigen Liganden der allgemeinen Formel 15a-3 enthält, sowie zumindest ein Wirtmaterial enthält.

8. Organisches Elektrolumineszenzelement gemäß Anspruch 7, worin das mindestens eine-Wirtmaterial lochtransportierend ist.

9. Organisches Elektrolumineszenzelement gemäß irgendeinem der Ansprüche 1 bis 8, worin das Stickstoff enthaltende heterocyclische Derivat als mindestens eines aus einem Elektroneninjektionsmaterial und einem Elektronentransportmaterial fungiert.

10. Organisches Elektrolumineszenzelement gemäß irgendeinem der Ansprüche 1 bis 9, worin die Schicht, die das Stickstoff enthaltende heterocyclische Derivat enthält, ein reduzierendes Dotiermittel enthält.

11. Organisches Elektrolumineszenzelement gemäß Anspruch 10, worin das reduzierende Dotiermittel mindestens eines ausgewählt aus Alkalimetallen, Erdalkalimetallen, Seltenerdmetallen, Alkalimetalloxiden, Alkalimetallhalogeniden, Erdalkalimetalloxiden, Erdalkalimetallhalogeniden, Seltenerdmetalloxiden, Seltenerdmetallhalogeniden, organischen Alkalimetallkomplexen, organischen Erdalkalimetallkomplexen und organischen Seltenerdmetallkomplexen ist.

## Revendications

1. Élément électroluminescent organique comprenant :
au moins une couche organique incluant une couche d'émission de lumière, entre une anode et une cathode,
dans lequel au moins une couche de l'au moins une couche organique contient au moins un choisi parmi des dérivés hétérocycliques contenant de l'azote représentés par la Formule Générale (1) ci-dessous, et au moins une couche de l'au moins une couche organique contient un matériau d'émission de lumière phosphoreux de transport d'électrons représenté par la Formule Générale (15a-3) ci-dessous, 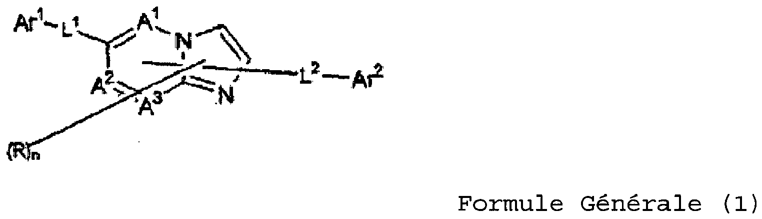 où A¹ à A³ représentent chacun indépendamment un atome d'azote ou un atome de carbone, Ar¹ représente un groupe aryle substitué ou non substitué ayant des atomes de carbone de noyau de 6 à 60 ou un groupe hétéroaryle substitué ou non substitué ayant des atomes de carbone de noyau de 3 à 60, Ar² représente un atome d'hydrogène, un groupe aryle substitué ou non substitué ayant des atomes de carbone de noyau de 6 à 60, un groupe hétéroaryle substitué ou non substitué ayant des atomes de carbone de noyau de 3 à 60, un groupe alkyle substitué ou non substitué ayant 1 à 20 atomes de carbone ou un groupe alcoxy substitué ou non substitué ayant 1 à 20 atomes de carbone, dans laquelle un parmi Ar¹ et Ar² est un groupe cyclique condensé substitué ou non substitué ayant 10 à 60 atomes de carbone de noyau ou un groupe cyclique monohétéro condensé substitué ou non substitué ayant 3 à 60 atomes de carbone de noyau ; L¹ et L² représentent chacun indépendamment une liaison simple, un groupe arylène substitué ou non substitué ayant 6 à 60 atomes de carbone de noyau, un groupe hétéroarylène substitué ou non substitué ayant 3 à 60 atomes de carbone de noyau ou un groupe fluorénylène substitué ou non substitué ; R représente un atome d'hydrogène, un groupe aryle substitué ou non substitué ayant 6 à 60 atomes de carbone de noyau, un groupe hétéroaryle substitué ou non substitué ayant des atomes de carbone de noyau de 3 à 60, un groupe alkyle substitué ou non substitué ayant 1 à 20 atomes de carbone ou un groupe alcoxy substitué ou non substitué ayant 1 à 20 atomes de carbone ; et n est un entier de 0 à 5, lorsque n est 2 ou plus, une pluralité de R peuvent être différents les uns des autres ou identiques, et des groupes R adjacents parmi la pluralité de R peuvent être liés pour former un noyau aliphatique carbocyclique ou un noyau aromatique carbocyclique, 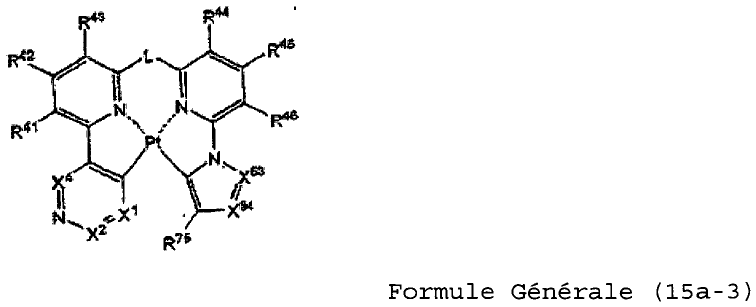 où X¹, X² et X⁴ représentent chacun indépendamment un atome de carbone ou un atome d'azote ; R⁴¹, R⁴², R⁴³, R⁴⁴, R⁴⁵ et R⁴⁶ représentent chacun indépendamment un atome d'hydrogène ou un substituant ; X⁵³ et X⁵⁴ représentent chacun indépendamment un atome de carbone ou un atome d'azote, le nombre d'atomes d'azote contenu dans un squelette de cycle à 5 éléments contenant X⁵³ et X⁵⁴ est 1 ou 2 ; R⁷⁵ représente un atome d'hydrogène ou un substituant ; et L représente une liaison simple ou un groupe de liaison divalent.

2. Élément électroluminescent organique selon la revendication 1, dans lequel au moins un choisi parmi les dérivés hétérocycliques contenant de l'azote représentés par la Formule Générale (1) est un dérivé hétérocyclique contenant de l'azote représenté par la Formule Générale (3) ci-dessous, 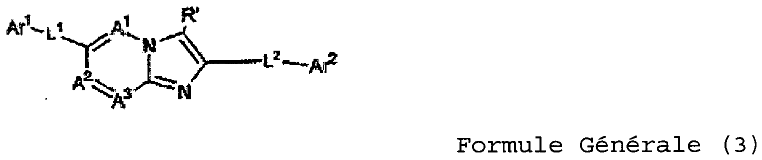 où A¹ à A³ représentent chacun indépendamment un atome d'azote ou un atome de carbone, Ar¹ représente un groupe aryle substitué ou non substitué ayant des atomes de carbone de noyau de 6 à 60 ou un groupe hétéroaryle substitué ou non substitué ayant des atomes de carbone de noyau de 3 à 60, Ar² représente un atome d'hydrogène, un groupe aryle substitué ou non substitué ayant des atomes de carbone de noyau de 6 à 60, un groupe hétéroaryle substitué ou non substitué ayant des atomes de carbone de noyau de 3 à 60, un groupe alkyle substitué ou non substitué ayant 1 à 20 atomes de carbone ou un groupe alcoxy substitué ou non substitué ayant 1 à 20 atomes de carbone, dans laquelle un parmi Ar¹ et Ar² est un groupe cyclique condensé substitué ou non substitué ayant des atomes de carbone de noyau de 10 à 60 ou un groupe cyclique monohétéro condensé substitué ou non substitué ayant des atomes de carbone de noyau de 3 à 60 ; L¹ et L² représentent chacun indépendamment une liaison simple, un groupe arylène substitué ou non substitué ayant 6 à 60 atomes de carbone de noyau, un groupe hétéroarylène substitué ou non substitué ayant 3 à 60 atomes de carbone de noyau ou un groupe fluorénylène substitué ou non substitué ; et R' représente un atome d'hydrogène, un groupe aryle substitué ou non substitué ayant 6 à 60 atomes de carbone de noyau, un groupe hétéroaryle substitué ou non substitué ayant 3 à 60 atomes de carbone de noyau, un groupe alkyle substitué ou non substitué ayant 1 à 20 atomes de carbone ou un groupe alcoxy substitué ou non substitué ayant 1 à 20 atomes de carbone.

3. Élément électroluminescent organique selon la revendication 2, dans lequel le dérivé hétérocyclique contenant de l'azote représenté par la Formule Générale (3) est un dérivé hétérocyclique contenant de l'azote représenté par la Formule Générale (4), 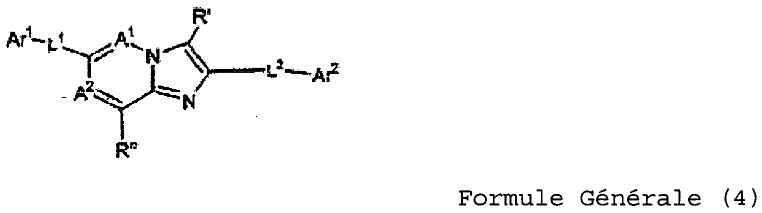 où A¹ et A² représentent chacun indépendamment un atome d'azote ou un atome de carbone, Ar¹ représente un groupe aryle substitué ou non substitué ayant des atomes de carbone de noyau de 6 à 60 ou un groupe hétéroaryle substitué ou non substitué ayant des atomes de carbone de noyau de 3 à 60, Ar² représente un atome d'hydrogène, un groupe aryle substitué ou non substitué ayant des atomes de carbone de noyau de 6 à 60, un groupe hétéroaryle substitué ou non substitué ayant des atomes de carbone de noyau de 3 à 60, un groupe alkyle substitué ou non substitué ayant 1 à 20 atomes de carbone ou un groupe alcoxy substitué ou non substitué ayant 1 à 20 atomes de carbone, dans laquelle un parmi Ar¹ et Ar² est un groupe cyclique condensé substitué ou non substitué ayant 10 à 60 atomes de carbone de noyau ou un groupe cyclique monohétéro condensé substitué ou non substitué ayant 3 à 60 atomes de carbone de noyau ; L¹ et L² représentent chacun indépendamment une liaison simple, un groupe arylène substitué ou non substitué ayant 6 à 60 atomes de carbone de noyau, un groupe hétéroarylène substitué ou non substitué ayant 3 à 60 atomes de carbone de noyau ou un groupe fluorénylène substitué ou non substitué ; et R' et R" représentent chacun indépendamment un atome d'hydrogène, un groupe aryle substitué ou non substitué ayant 6 à 60 atomes de carbone de noyau, un groupe hétéroaryle substitué ou non substitué ayant 3 à 60 atomes de carbone de noyau, un groupe alkyle substitué ou non substitué ayant 1 à 20 atomes de carbone ou un groupe alcoxy substitué ou non substitué ayant 1 à 20 atomes de carbone, R' et R" peuvent être différents l'un de l'autre ou identiques.

4. Élément électroluminescent organique selon l'une quelconque des revendications 1 à 3, dans lequel, dans le dérivé hétérocyclique contenant de l'azote représenté par l'une quelconque des Formules Générales (1), (3) et (4), au moins un parmi L¹ et L² est choisi parmi des groupes représentés chacun indépendamment par des Formules Structurelles ci-dessous :

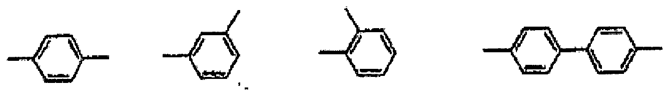

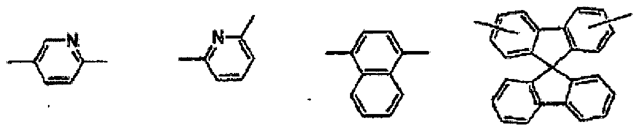

5. Élément électroluminescent organique selon l'une quelconque des revendications 1 à 4, dans lequel, dans le dérivé hétérocyclique contenant de l'azote représenté par l'une quelconque des Formules Générales (1), (3) et (4), Ar¹ est un groupe représenté par l'une quelconque des Formules Générales (5) à (14) ci-dessous : 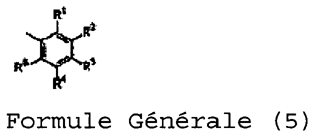 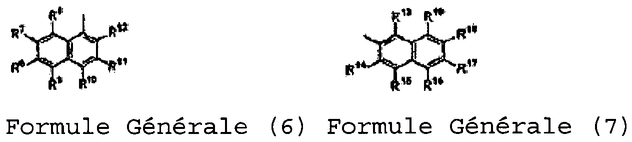 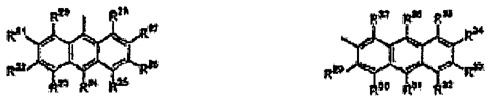 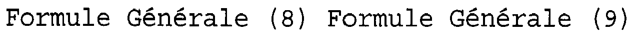 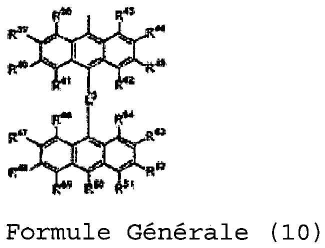 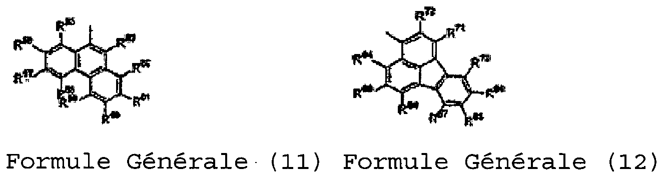 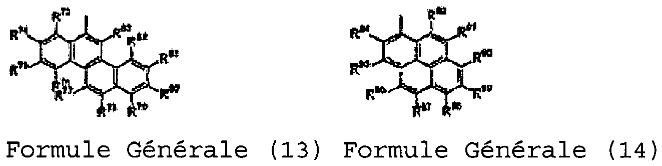 où R¹ à R⁹² représentent chacun indépendamment un atome d'hydrogène, un atome d'halogène, un groupe alkyle substitué ou non substitué ayant 1 à 20 atomes de carbone, un groupe alcoxy substitué ou non substitué ayant 1 à 20 atomes de carbone, un groupe aryloxy substitué ou non substitué ayant 6 à 40 atomes de carbone de noyau, un groupe diarylamino substitué ou non substitué ayant 12 à 80 atomes de carbone de noyau, un groupe aryle substitué ou non substitué ayant 6 à 40 atomes de carbone de noyau, un groupe hétéroaryle substitué ou non substitué ayant 3 à 40 atomes de carbone de noyau, ou un groupe diarylaminoaryle substitué ou non substitué ayant 18 à 120 atomes de carbone de noyau ; et L³ représente une liaison simple ou un substituant représenté par l'une quelconque des Formules Structurelles ci-dessous :

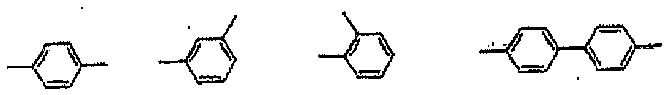

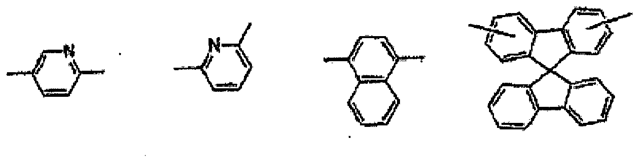

6. Élément électroluminescent organique selon l'une quelconque des revendications 1 à 5, dans lequel la couche d'émission de lumière contient au moins un parmi un composé complexe de métal contenant un ligand polydentate ayant une structure partielle représentée par la Formule Générale (2) et le composé complexe de platine contenant le ligand tétradentate représenté par la Formule Générale 15a-3, 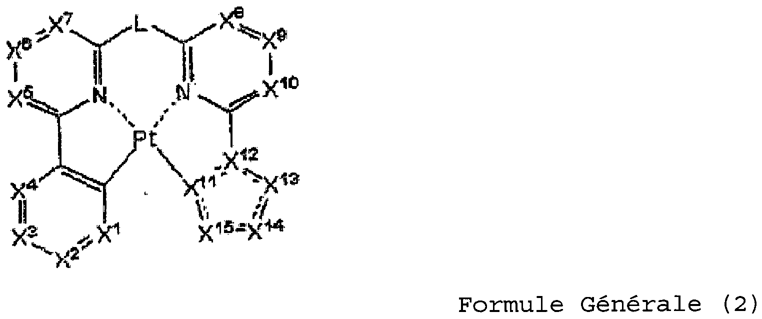 où X¹, X², X³ et X⁴ représentent chacun indépendamment un atome de carbone ou un atome d'azote, et un ou plusieurs choisis parmi X¹, X², X³ et X⁴ représente(nt) un atome d' azote ; X⁵, X⁶, X⁷, X⁸, X⁹ et X¹⁰ représentent chacun indépendamment un atome de carbone ou un atome d'azote ; X¹¹ et X¹² représentent chacun indépendamment un atome de carbone ou un atome d'azote ; X¹³, X¹⁴ et X¹⁵ représentent chacun indépendamment un atome de carbone, un atome d'azote, un atome d'oxygène ou un atome de soufre, le nombre d'atomes d'azote contenu dans un squelette de cycle à 5 éléments représenté par l'un quelconque parmi X¹¹, X¹², X¹³, X¹⁴ et X¹⁵ est 2 ou plus petit ; et L représente une liaison simple ou un groupe de liaison divalent.

7. Élément électroluminescent organique selon l'une quelconque des revendications 1 à 6, dans lequel la couche d'émission de lumière contient au moins un parmi un composé complexe de métal contenant un ligand polydentate ayant une structure partielle représentée par la Formule Générale (2), un composé complexe de platine contenant un ligand tétradentate représenté par la Formule Générale 15a-3, et au moins un matériau hôte.

8. Élément électroluminescent organique selon la revendication 7, dans lequel l'au moins un matériau hôte est transportable par les trous.

9. Élément électroluminescent organique selon l'une quelconque des revendications 1 à 8, dans lequel le dérivé hétérocyclique contenant de l'azote fonctionne comme au moins un parmi un matériau d'injection d'électrons et un matériau de transport d'électrons.

10. Élément électroluminescent organique selon l'une quelconque des revendications 1 à 9, dans lequel la couche contenant le dérivé hétérocyclique contenant de l'azote contient un dopant réducteur.

11. Élément électroluminescent organique selon la revendication 10, dans lequel le dopant réducteur est au moins un choisi parmi des métaux alcalins, des métaux alcalinoterreux, des métaux des terres rares, des oxydes de métal alcalin, des halogénures de métal alcalin, des oxydes de métal alcalinoterreux, des halogénures de métal alcalinoterreux, des oxydes de métal des terres rares, des halogénures de métal des terres rares, des complexes organiques de métal alcalin, des complexes organiques de métal alcalinoterreux, et des complexes organiques de métal des terres rares.
